# EUROPEAN PATENT APPLICATION

(11) **EP 4 198 717 A1**
(43) Date of publication of application: **21.06.2023**
(21) Application number: 22208089.7
(22) Date of filing: 17.11.2022
(51) Int. Cl.: G06F 9/30

(54) **REGISTER FILE VIRTUALIZATION: APPLICATIONS AND METHODS**

(30) Priority: 17.12.2021 US 202117555174
(71) Applicant: Intel Corporation, Santa Clara, CA 95054 (US)
(72) Inventor: BUTERA, William, Newton, MA 02465 (US); WEBB, David, Little Compton, RI 02837 (US); DIAMOND, Mitchell, Shrewsbury, MA 01545 (US); HSU, Steven, Lake Oswego, OR 97035 (US); AGARWAL, Amit, Hillsboro, OR 97124 (US)
(74) Representative: Samson & Partner Patentanwälte mbB

(57) **Abstract**

Methods and apparatus relating to register file virtualization techniques are described. In an embodiment, a register file includes a plurality of register file cells. Each of the register file cells includes a register file entry and a shadow buffer. Logic circuitry causes storage of input data to the shadow buffer, while data stored in the register file entry is accessible to perform one or more operations. Other embodiments are also disclosed and claimed.

## Description

### FIELD

The present disclosure generally relates to the field of processors. More particularly, some embodiments relate to the applications and/or methods of register file virtualization.

### BACKGROUND

Generally, a register file of a processor includes a plurality of processor registers. In modern processors, Static Random-Access Memory (SRAM) is used to implement a register file. To improve performance, register files may be implemented with separate read and write ports.

Since processor operations rely on register files to store data for various processor operations, implementation of a register file can have a direct impact on processor performance.

### BRIEF DESCRIPTION OF THE DRAWINGS

The detailed description is provided with reference to the accompanying figures. In the figures, the left-most digit(s) of a reference number identifies the figure in which the reference number first appears. The use of the same reference numbers in different figures indicates similar or identical items.
FIG. 1 illustrates an expanded register file cell in accordance with an embodiment.
FIGs. 2A, 2B, 2C, and 2D illustrate sample register file transport modes, according to some embodiments.
FIG. 3 illustrates snap shots in time of streaming load operations in shadow buffers in background, according to some embodiments.
IG. 4 illustrates a block diagram of a register file partitioned into multiple domains, according to an embodiment.
FIG. 5 illustrates a block diagram of pipeline processing of data blocks with dynamic state, according to an embodiment.
FIG. 6 illustrates components for a flash-switch extension to flashing modes, according to an embodiment.
FIG. 7 illustrates a flow diagram of a method for a two-level nested loop operating on a virtual register file, according to an embodiment.
FIG. 8A illustrates an expanded register file entry with buffer, streaming bus, and control for sequenced latching, according to an embodiment.
FIGs. 8B and 8C illustrate further details regarding settings and controls for the expanded register file entry of FIG. 8A, according to some embodiments.
FIG. 9A illustrates a block diagram of a system to provide a register file stream mode, according to an embodiment.
FIGs. 9B, 9C, and 9D illustrate further details regarding the system of FIG. 9A, according to some embodiments.
FIG. 10A is a block diagram illustrating an exemplary instruction format according to embodiments.
FIG. 10B is a block diagram illustrating the fields of the instruction format that make up the full opcode field according to one embodiment.
FIG. 10C is a block diagram illustrating the fields of the instruction format that make up the register index field according to one embodiment.
FIG. 10D is a block diagram illustrating the fields of the instruction format that make up the augmentation operation field according to one embodiment.
FIG. 11 is a block diagram of a register architecture according to one embodiment.
FIG. 12A is a block diagram illustrating both an exemplary in-order pipeline and an exemplary register renaming, out-of-order issue/execution pipeline according to embodiments.
FIG. 12B is a block diagram illustrating both an exemplary embodiment of an in-order architecture core and an exemplary register renaming, out-of-order issue/execution architecture core to be included in a processor according to embodiments.
FIG. 13 illustrates a block diagram of a System On Chip (SOC) package in accordance with an embodiment.
FIG. 14 is a block diagram of a processing system, according to an embodiment.
FIG. 15 is a block diagram of an embodiment of a processor having one or more processor cores, according to some embodiments.
FIG. 16 is a block diagram of a graphics processor, according to an embodiment.

### DETAILED DESCRIPTION

In the following description, numerous specific details are set forth in order to provide a thorough understanding of various embodiments. However, various embodiments may be practiced without the specific details. In other instances, well-known methods, procedures, components, and circuits have not been described in detail so as not to obscure the particular embodiments. Further, various aspects of embodiments may be performed using various means, such as integrated semiconductor circuits ("hardware"), computer-readable instructions organized into one or more programs ("software"), or some combination of hardware and software. For the purposes of this disclosure reference to "logic" shall mean either hardware (such as logic circuitry or more generally circuitry or circuit), software, firmware, or some combination thereof.

As mentioned above, implementation of a register file can have a direct impact on processor performance. Generally, a Register File (RF) design and operation poses two issues. The first is the micro-architectural limitations imposed by the size of the RF (number of entries). The second is the latency of blocking transfers between the RF and the next level of memory, e.g., a SRAM backing store.

For example, in the general case of a tiled array accelerator with shared access to an SRAM backing store, the size of the RF can set the de facto limit on the size of the working set that can run at peak performance. In a target case of a multithreaded Single Instruction, Multiple Data (SIMD) processor (e.g., of a Graphics Processing Unit (GPU)), the number of entries in a SIMD lane's RF also sets the upper bound on the number of threads that can be concurrently active.

Additionally, in the general case of an RF exchanging data with a SRAM backing store, the transfer rate is ultimately limited by the number of write ports to the RF - typically 1-8 ports. In this regime, much of the state data for concurrent threads need to be resident in the RF, as opposed to being loaded from the backing store on demand. Another limitation is the size of the backing store itself. Here, a 'miss' to that store incurs a latency penalty which, per Little's Law, can require additional threads to mask.

Furthermore, some implementations for increasing the size of the RF can leverage the increased densities of advanced fab processes (e.g., from a 10 nanometer (nm) node to a 7 nm node), and moves to alternate storage types (e.g., from dynamic to static latch-based storage). Likewise, increasing device density, together with 2.5 dimensional (2.5D) and three-dimensional (3D) integration techniques, may be employed to increase the size of the SRAM store. However, continuing efforts to grow both the size and the access bandwidth of the RF are hitting diminishing returns. Namely, the size of high port-count RFs can typically be bounded by the area of the wire tracks. Yet the shrinking feature sizes of advanced fabrication processes disproportionately favor increases in device density, yielding only modest gains in the density of the upper metal layers. Also, 3D placement of disaggregated memory may enable larger backing stores but can also result in routing the interconnect across die-to-die boundaries, where the signal density is much lower than the in-plane interconnect.

To address at least some of these issues, one or more embodiments provide techniques for register file virtualization. In an embodiment, hardware enablement for RF virtualization is provided, e.g., an instance of where an RF of a given physical capacity (X entries) is functionally equivalent to an RF of a larger capacity (X + D entries, where "D" refers to additional capacity). One embodiment maps one or more latency hiding techniques directly to the design of the register file. Also, hardware extensions to the RF entries enable parallel streaming of data between the SRAM backing store and integrated shadow buffers in some embodiments. Additionally, various flash modes may support single-cycle flash-fill transfers between the shadow buffers and the RF entries. Groups of RF entry buffer pairs may further be dynamically partitioning into "domains," each with a selectable mode for latching and transport.

As a result, many micro-architectures that are performance-bound by the capacity and refresh rate of the register file may see workload-dependent gains in performance. In one embodiment, the functional size of the "Virtual RF" can be as large as the private memory backing store. The performance gains from this approach may be strongest in instances where 3D integration positions high capacity backing stores on a separate die that is vertically aligned with the compute die containing the RF.

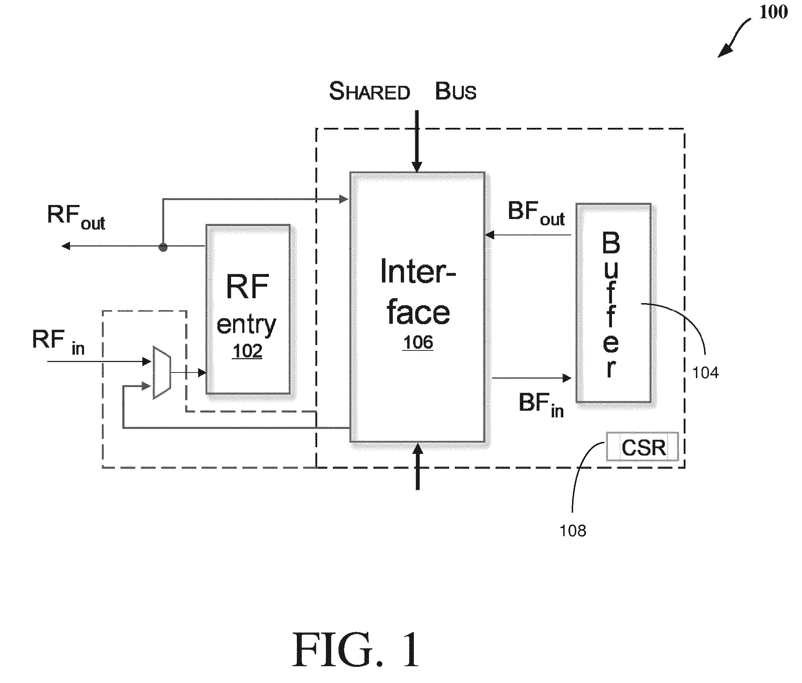

FIG. 1 illustrates an expanded register file cell 100 in accordance with an embodiment. As shown in FIG. 1, a single RF entry 102 is extended to include an additional shadow buffer 104 and additional logic for mode control interface circuitry 106.

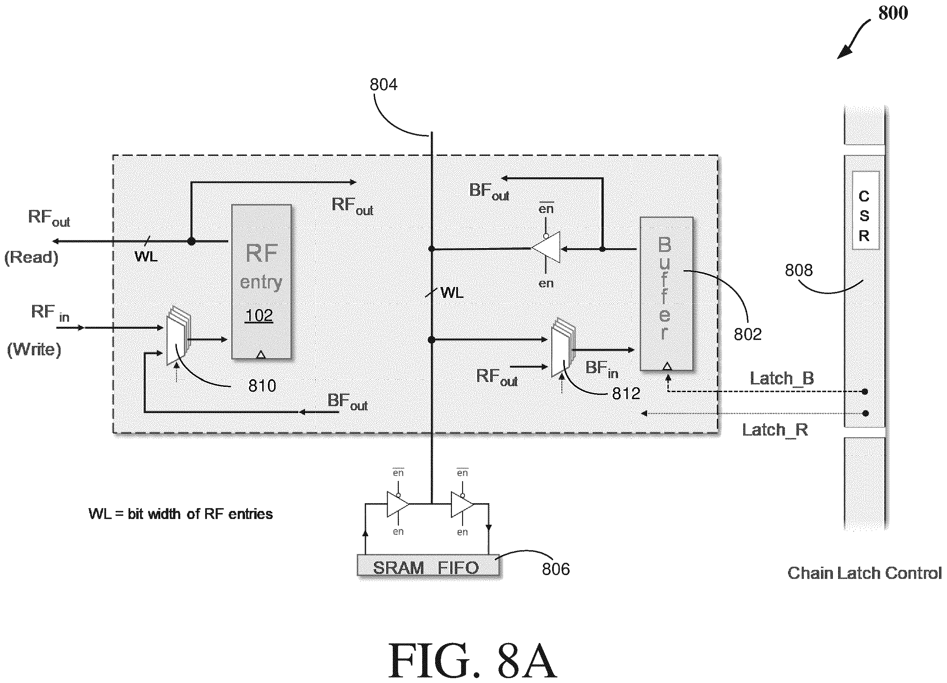

In one embodiment, the shadow buffer 104 (which is a latch in an embodiment) has the same capacity as the RF entry 102. The interface circuitry 106 enables two separate modes for latching and transport: (1) a foreground-background mode; and (2) a flash-fill mode. Moreover, the operation of each of these expanded RF-entry `cells' may be controlled independently by a (e.g., 4-bit) Control Status Register (CSR) 108, which may be embedded in each cell in at least one embodiment. In an embodiment, the CSR 108 is dynamically loadable. Further component-level and signal-level details of such an implementation are discussed with reference to FIG. 8A.

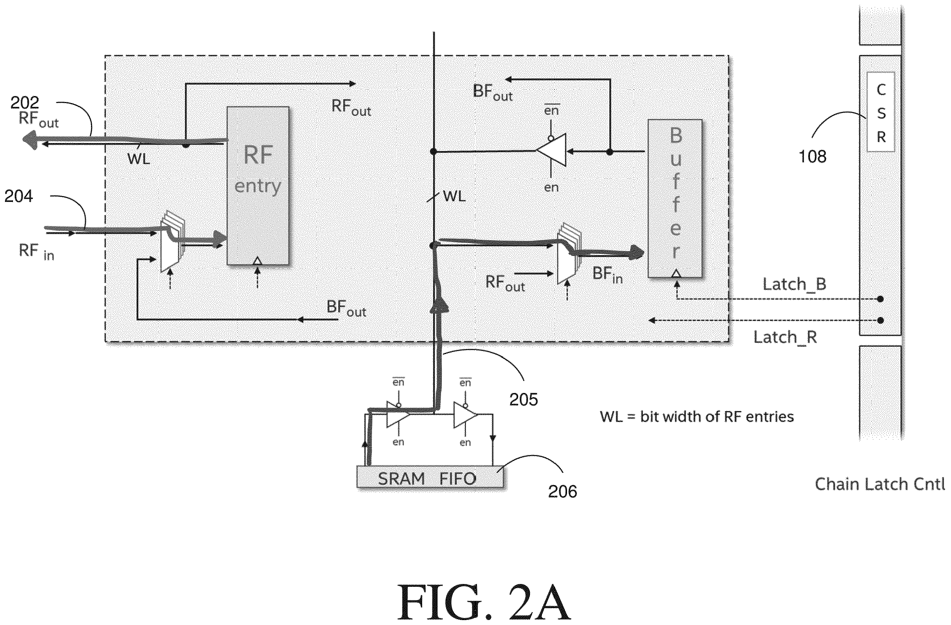

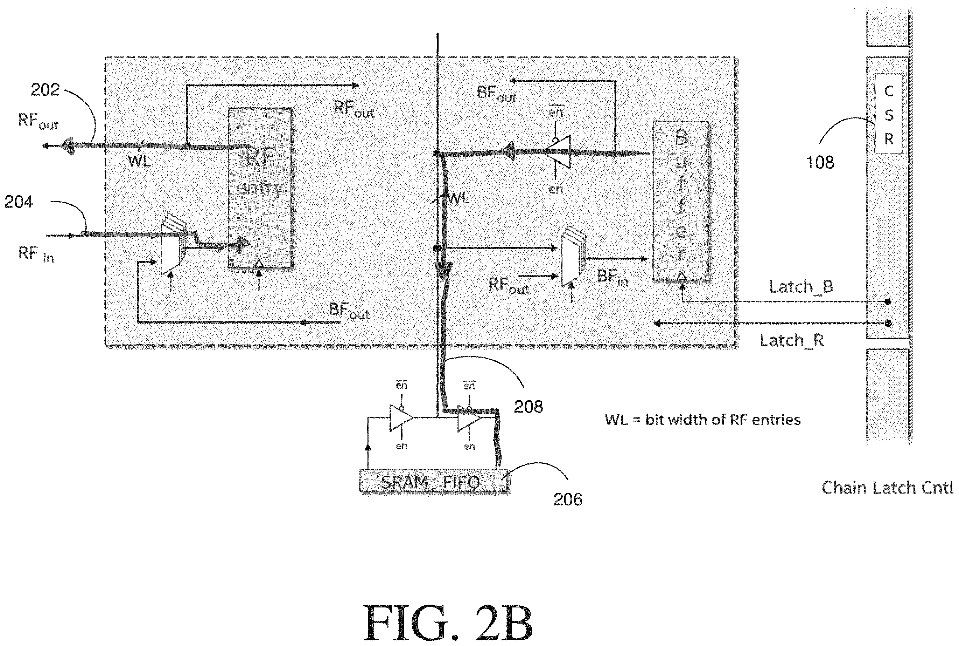

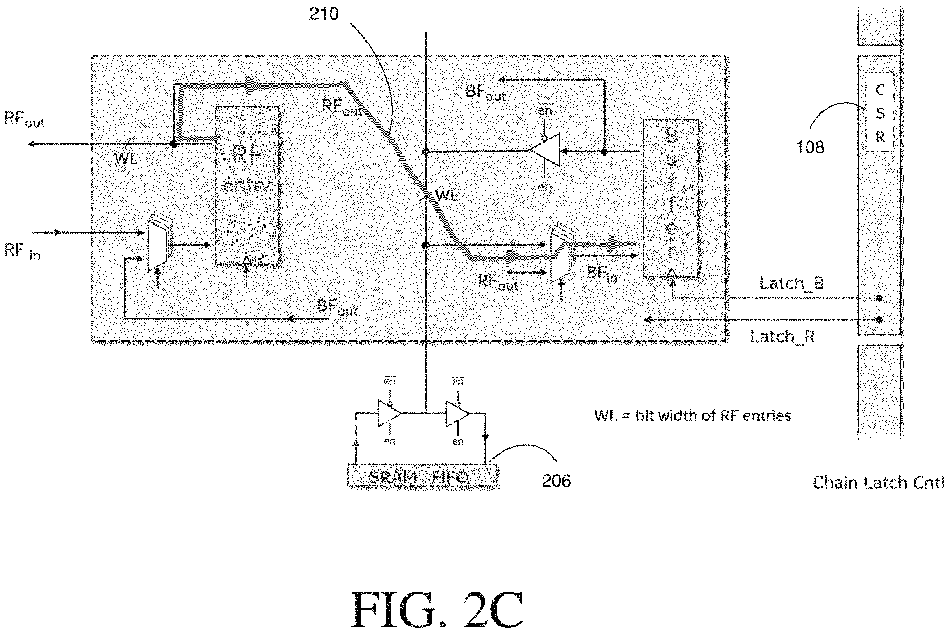

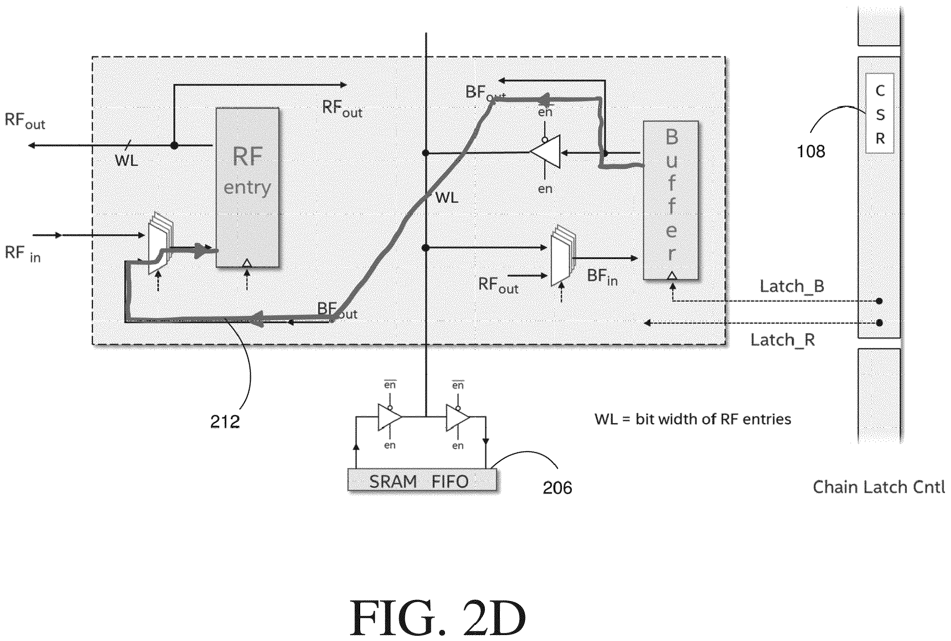

FIGs. 2A, 2B, 2C, and 2D illustrate sample register file transport modes, according to some embodiments. The expanded register file would consist of a cascade of the expanded RF-entry cells 100. The transport modes shown in FIGS. 2A, 2B, 2C, and 2D allow for register file virtualization in various embodiments.

FIG. 2A illustrates RF mode read/write and a buffer mode load from SRAM for a foreground-background mode. FIG. 2B illustrates RF mode read/write and a buffer mode to store to SRAM for a foreground-background mode. FIG. 2C illustrates a flash RF to buffer for a register to shadow buffer operation for a flash-fill mode. FIG. 2D illustrates a flash buffer to RF for a shadow buffer to register operation for a flash-fill mode.

More particularly, FIG. 2A illustrates the foreground-background mode in accordance with an embodiment. Here, the register file entries service load (202) and stores (204) to the compute pipeline in the foreground. In the background, the buffer is being loaded (205) from the SRAM port 206. In one embodiment, in the background mode, the CSRs (108) configure selected cells of the RF to route buffer contents to the outbound neighbor. In the foreground mode, RF entries service the access requests from the compute pipeline.

In an embodiment, the direction of the background streaming is selectable, and can be set to a streaming store-to-SRAM (208) as well, e.g., as shown in FIG. 2B. In the figures that follow, this background transfer is implemented as a shift register First In, First Out (FIFO) operation in accordance with one embodiment. But, in other embodiments, the actual transfers may use structures such as `open latch' routing or a dedicated bus. Additional circuit details are shown in FIG. 8A in accordance with one embodiment.

FIG. 2C shows the flash-fill mode in accordance with an embodiment. Here, the contents of the entire register file are being flashed to the shadow buffer (210), e.g., all in a single cycle. Hence, the contents of each RF entry are flashed to that cell's shadow buffer in a single cycle. Similarly, the transfer can proceed from the shadow buffers to the register file entries (212) such as illustrated in FIG. 2D. For FIG. 2C, in each cell, the corresponding CSR can configure a direct signal path from the output of the RF entry (RFₒᵤₜ) to the input of the shadow buffer (BFᵢₙ). In this mode, there is no communication between the cells. Similarly, for FIG. 2D, the CSR can configure a direct signal path from the output of the shadow buffer (BFₒᵤₜ) to the input of the RF cell (RFin).

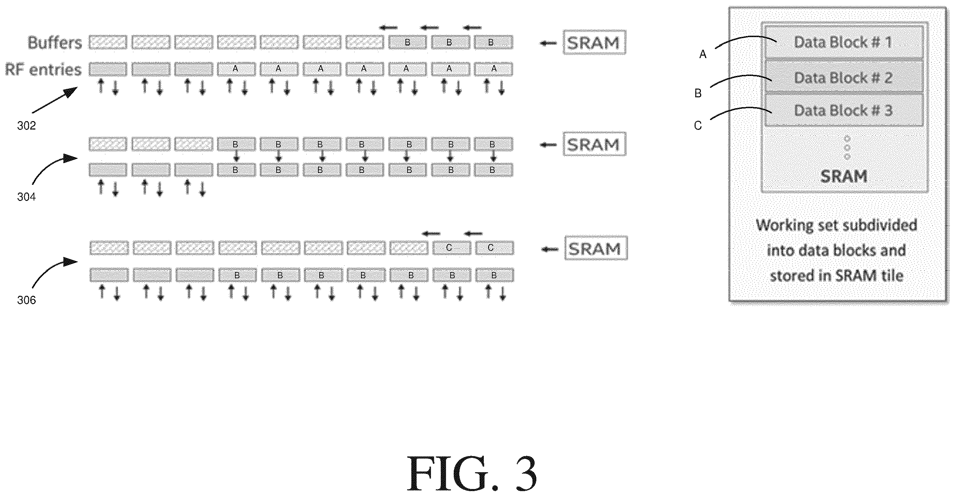

FIG. 3 illustrates snap shots in time of streaming load operations in shadow buffers in background, according to some embodiments. One basic transport flow is simple pipelining of static data blocks. The working set is assumed to be subdivided into blocks (labeled as blocks #1, #2, and #3) and stored in the SRAM backing store. Each block is assumed to be small enough to fit in the register file. Data in the blocks is assumed to be static, which is to say that any changes to their contents do not have to be saved.

Moreover, FIG. 3 shows three snapshots of time (302, 304, and 306). Each snapshot consists of two rows; the blocks on the bottom row are the individual register file entries. The blocks on the top row are their respective shadow buffers. The top-most snapshot (302) shows the foreground-background mode, where data block #1 (A) is active in the register file and is servicing loads/stores to compute pipes. In the background, data block #2 (B) is being streamed in from SRAM. In the middle snapshot (304), the load of data block #2 is complete, and its contents are flashed to the register file entries. In the lower snapshot (306), the process repeats, with compute being performed on data block # 2 while data block # 3 (C) is being loaded into the shadow buffers.

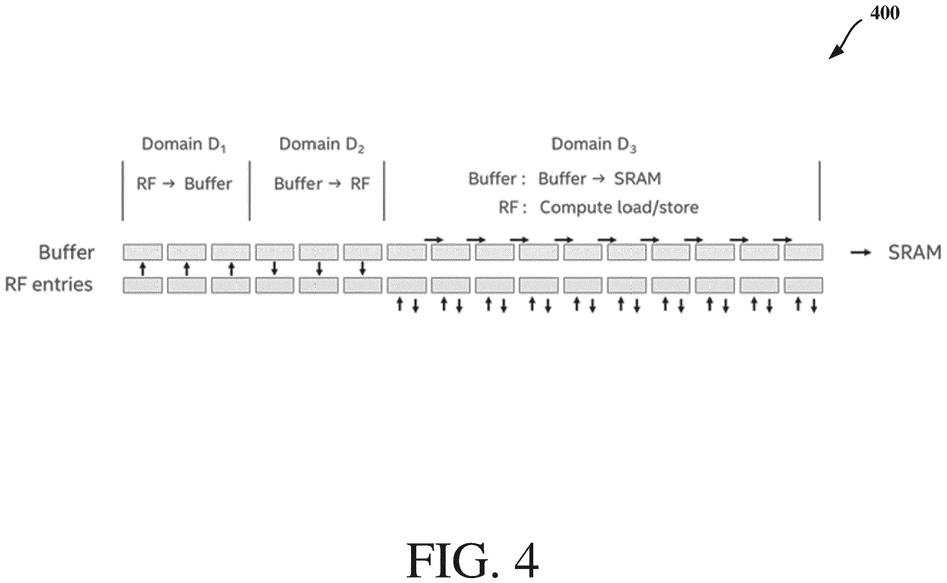

FIG. 4 illustrates a block diagram of a register file 400 partitioned into multiple domains, according to an embodiment. An extension of the design of FIG. 3 is the ability to dynamically partition the register file into independent domains, each with a selectable mode for latching and transport.

In the example of FIG. 4, the register file has been subdivided into three domains (labeled as D₁, D₂, and D₃ in FIG. 4). In domain D₁, the contents of the register file entries are being latched into the shadow buffers. In domain D₂, the shadow buffer contents are being latched into the register entries, e.g., potentially in the same clock cycle that domain D₁ is transferring in the opposite direction. Finally, domain D₃ is operating in the foreground-background mode, with the buffer data streaming to the SRAM.

In various embodiments, the domain size and/or transport mode are dynamically configurable, with the minimum domain size being a single register file entry. Domain partitioning enables the pipelining of data blocks with a dynamic state. In other words, the hardware can now efficiently load a data block from SRAM, change its state as part of the compute, and then store the transformed block back to the SRAM.

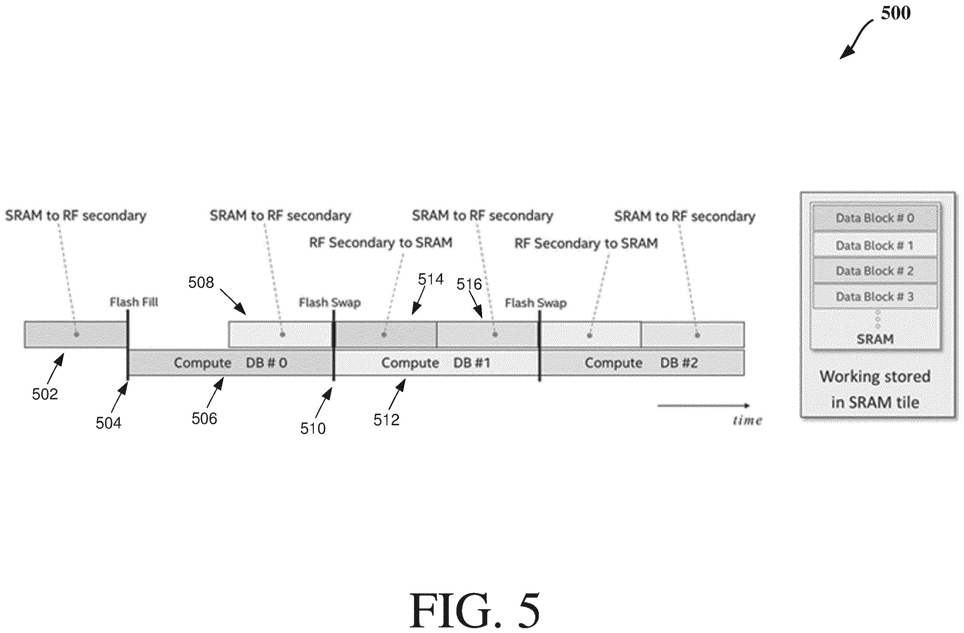

FIG. 5 illustrates a block diagram of pipeline processing 500 of data blocks with dynamic state, according to an embodiment. In the illustration of FIG. 5, the working set is subdivided into data blocks and stored in the SRAM backing store. The timeline graphic shows the temporal flow (in this figure, the label "RF Secondary" refers to the shadow buffers). In essence, this is a repetitive cycle of: (1) operating on one block in the foreground; and (2) while in the background: (i) sequentially saving the work on the previous block, and (ii) subsequently preloading the next block.

Considering the first two cycles from FIG. 5: (a) on the far left, data block #0 (DB #0) has been loaded into the shadow buffers 502 (labeled here as RF secondary); (b) the flash-fill 504 moves block #0 into the register file; (c) immediately after the flash-fill, compute on the block #0 begins in the foreground 506, while the load of block #1 into the secondary begins in the background 508; (d) once compute on block #0 completes, a single-cycle flash-swap occurs 510. For this flash-swap the register file was divided into two domains. In one domain, the transformed contents of block #0 are flash-filled from the register file into the secondary. In the other domain, block #1 is flash-filled from the secondary into the register file; (e) once that flash-swap is done, compute on block #1 begins in the foreground 512; (f) parallel to this, in the background, the transformed contents of previous block - block #0 - are first streamed back to the SRAM 514, and then the data from the next block - block #2 - is streamed out of the SRAM into secondary 516. This cycle of foreground compute on one block, together with: (i) background writeback of the previous block, and (ii) prefetch of the next block, is repeated until all the blocks in the SRAM have been processed.

Beyond the operational specifics, the example of FIG. 5 indicates that the functional capacity of the "virtual register file" can be substantially larger than the capacity of the physical one. With appropriate sizing of the blocks and of the compute time per block, the functional capacity of the "virtual register file" can be as large as the SRAM backing store itself in at least one embodiment.

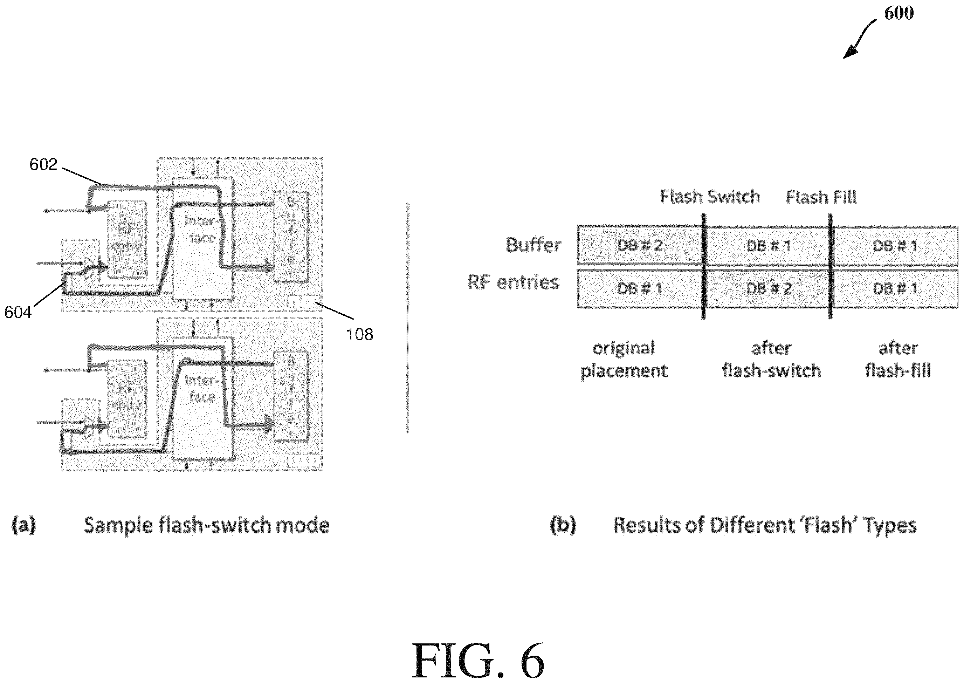

FIG. 6 illustrates components for a flash-switch extension to flashing modes, according to an embodiment. Additional extensions to the RF that enable a 'flash-switch' mode are disclosed with reference to FIG. 6. Here, the latch-based shadow buffer is replaced with a flip-flop. The foreground-background mode remains unchanged. But, the 'flash-fill' mode is expanded to include a flash-switch option, e.g., one where the contents of the register file entry and the shadow buffer are exchanged in-place, as opposed to one of them being overwritten.

More particularly, FIG. 6(a) illustrates the bi-direction signal flow between the register file entry and its shadow buffer (602/604). In each cell, CSR 108 configures direct exchange of contents between RF entry and shadow buffer (e.g., a flip-flop). As shown, there is no communication between the cells.

FIG. 6 (b) compares the effects of a flash-switch with that of a flash-fill. One difference is that the flash-switch exchanges the contents of primary and secondary storage in-place, while the flash-fill overwrites the contents of the target. While there is the potential for a strong performance upside, the move to a flip-flop-based shadow buffer can increase the incremental cost for power and/or area.

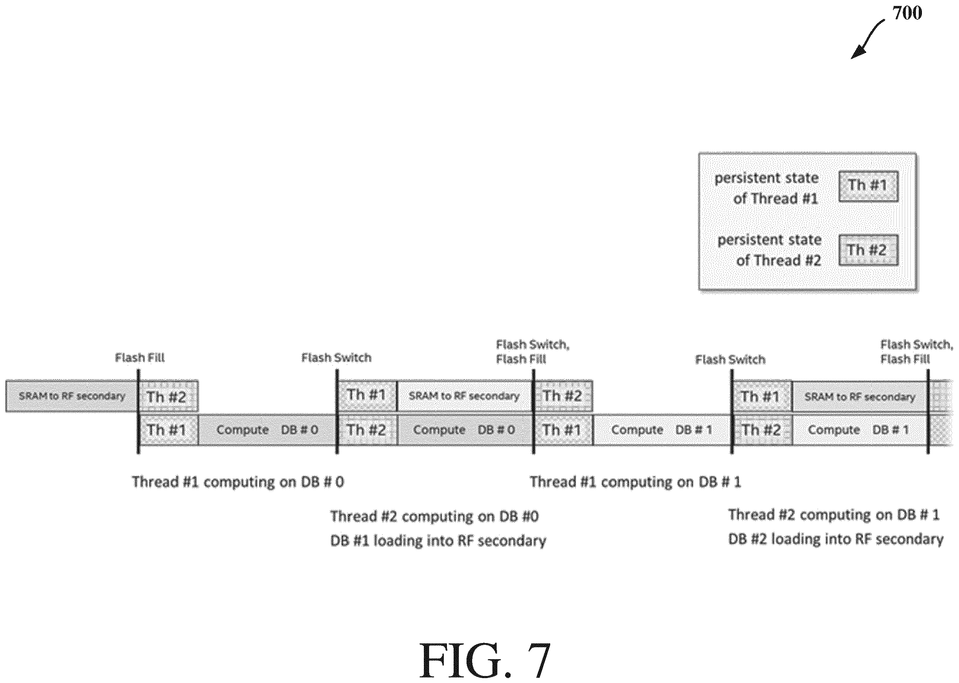

FIG. 7 illustrates a flow diagram of a method 700 for a two-level nested loop operating on a virtual register file, according to an embodiment. In an embodiment, FIG. 7 depicts a notional example for the operation of a flash-switch mode, according to an embodiment. The working set is subdivided into data blocks and stored in the SRAM backing store. Here, each data block is operated on by two independent threads, each with persistent state.

This example is structured as a two-level nested loop. The outer loop reads in the blocks sequentially. The inner loop operates on each block with two threads, each thread with persistent storage in the register file. Flash-switch operations toggle between the threads as part of the inner loop. Flash-fill operations cycle through the blocks as part of the outer loop.

In core micro-architectures with complex hardware flows for RF renaming, this approach may become problematic. But, in the specialized RF designs of dedicated accelerators, the proposed hardware extensions may be an easier fit. Referring to FIG. 7, the example above would be a meaningful instance of the apparent capacity of the `virtual register file' growing to the actual physical capacity of the SRAM backing store.

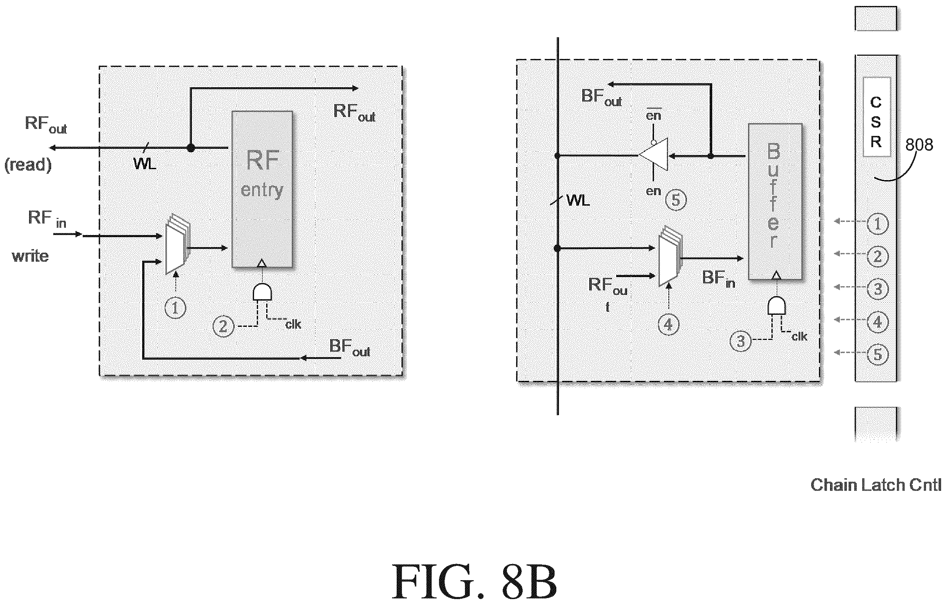

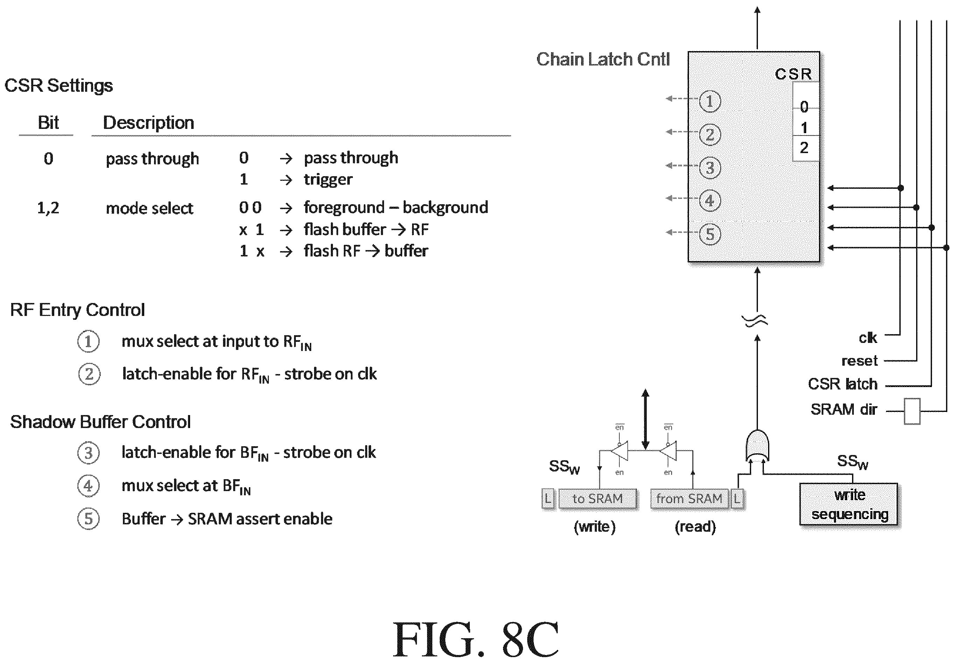

FIG. 8A illustrates an expanded register file entry 800 with buffer, streaming bus, and control for sequenced latching, according to an embodiment. FIGs. 8B and 8C illustrate further details regarding settings and controls for the expanded register file entry of FIG. 8A, according to some embodiments. The sketch of FIG. 8A illustrates the component groups and signaling for a single RF-entry cell. The component groups shown here are: (1) the storage element for the RF entry 102; (2) the shadow buffer 802 (e.g., a latch for unidirectional flash-fills and a flip-flop for bidirectional flash-switch); (3) a single shared write bus 804 for streaming between the SRAM 806 and the shadow buffers 802; and (4) a control strip 808 that sequences the access to the write bus by the buffers and SRAM.

Moreover, FIG. 8A indicates that for the hardware extensions for RF virtualization, the primary adders for power and/or area are the additional storage element and the single wire track that is common to all the RF entries. This design calls for the addition of one shared write bus 804, independent of the number of read/write ports in the register file. Hence, this design approach is well-suited for RF structures that are wire track bound, but where the device layer is underutilized. Here, the inherent cost of doubling the storage elements (e.g., with insertion of shadow buffers) is moderated by the unused devices, and the addition of a single wire track can be seen as an acceptable incremental cost for the added performance.

As shown in FIG. 8A, within a register file, a physical characteristic of some embodiments is an array of shadow buffers that are (e.g., all) interconnected to a single shared wire track 804, but with no signal paths to the RF read/write ports. The shadow buffers would be 1:1 paired with the individual registers, with a multiplexer arbitrated signal path (e.g., using multiplexer(s) 810/812) between each register and its respective shadow buffer.

FIGs. 8B and 8C illustrate further details regarding settings and controls for the expanded register file entry of FIG. 8A, according to some embodiments. More specifically, FIG. 8B includes five connections originating from the Chain_Latch_Cntl 808 and coupling to components of the RF entry and shadow buffer, numbered one through five with circles. FIG. 8C provides additional details regarding each of the five connections. FIG. 8C also shows sample CSR settings in accordance with a three-bit configuration. In FIG. 8C, "SS_{w}" stands for Source Synchronous write (where "w" stands for write) and "SRAM dir" refers to the direction of data flow (e.g., flowing from the buffers to/from SRAM). The write Sequencing block is used to clock the buffers to send data to the SRAM. The write sequencer is a counter, which may determine how many values to send to the SRAM. This counter may also be set for a specific delay between pulses sent to the SRAM.

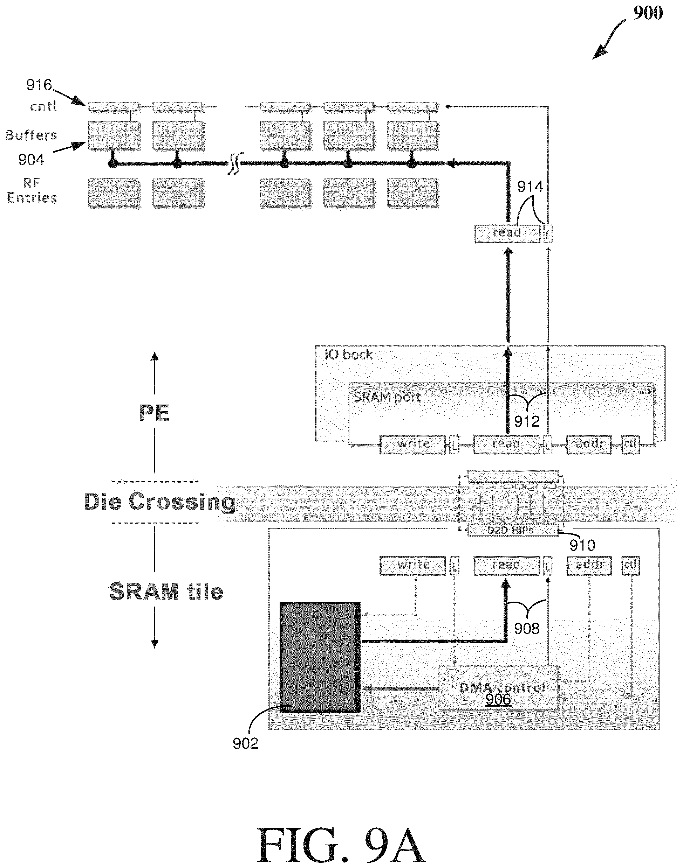

FIG. 9A illustrates a block diagram of a system 900 to provide a register file stream mode, according to an embodiment. For example, for a streaming read (e.g., SRAM 902 to shadow buffers 904), a Direct Memory Access (DMA) controller 906 asserts a read address to the SRAM 902. As a result, SRAM data and source synchronous latch signals 908 are latched for input to the die-to-die (D2D) custom analog circuit, such as a Hard Intellectual Property (HIP) interface 910.

Data and latch signals 912 are latched at a Processing Element's (PE's) SRAM port. Optionally a final repeater 914 can be used before entry into the shadow buffer chain 904. In turn, control logic 916 (control slice) strobes the data from the common bus into target shadow buffer(s) 904. Hence, in an embodiment, SRAM data is loaded into the shadow buffers 904 while the register files are servicing the compute pipelines. And, once the transfer from SRAM to the shadow buffers is complete, one or two clock cycles are sufficient to flash the entire content of the shadow buffers into the register file entries. In at least one embodiment, latency of accessing data stored in an SRAM (e.g., on a different die in a package with or without stacked dies) is hidden for register file implementations.

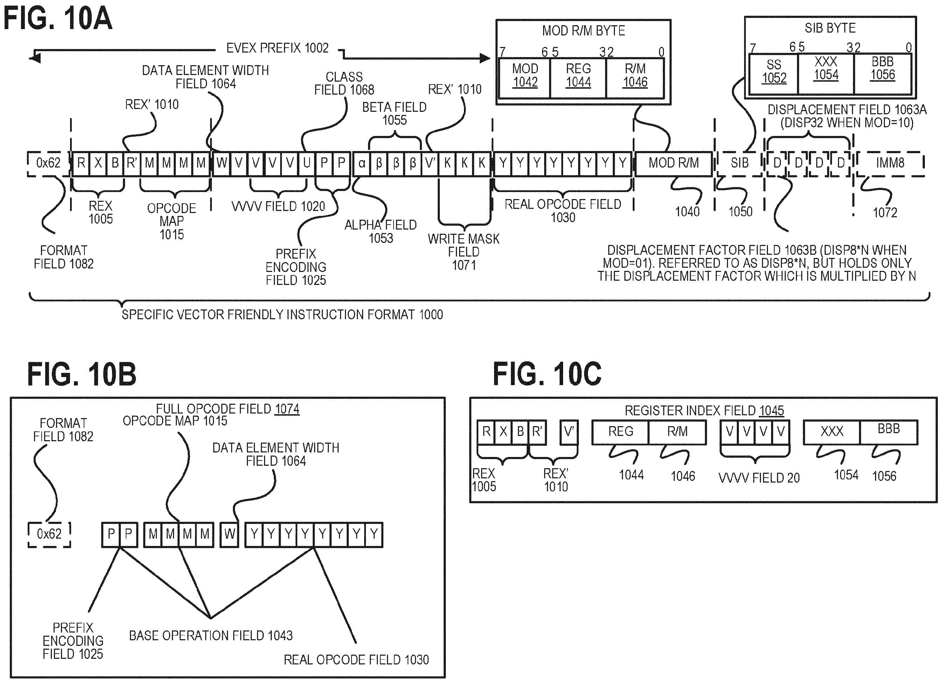

Further, in some embodiments, one or more instructions may be utilized to control various features of embodiments discussed herein, including initiating a background transfer of data from the backing storage (e.g., SRAM) into the RF shadow buffers. In at least some embodiments, one or more of the instructions discussed herein may follow the instruction format discussed with reference to FIGs. 10A-10D.

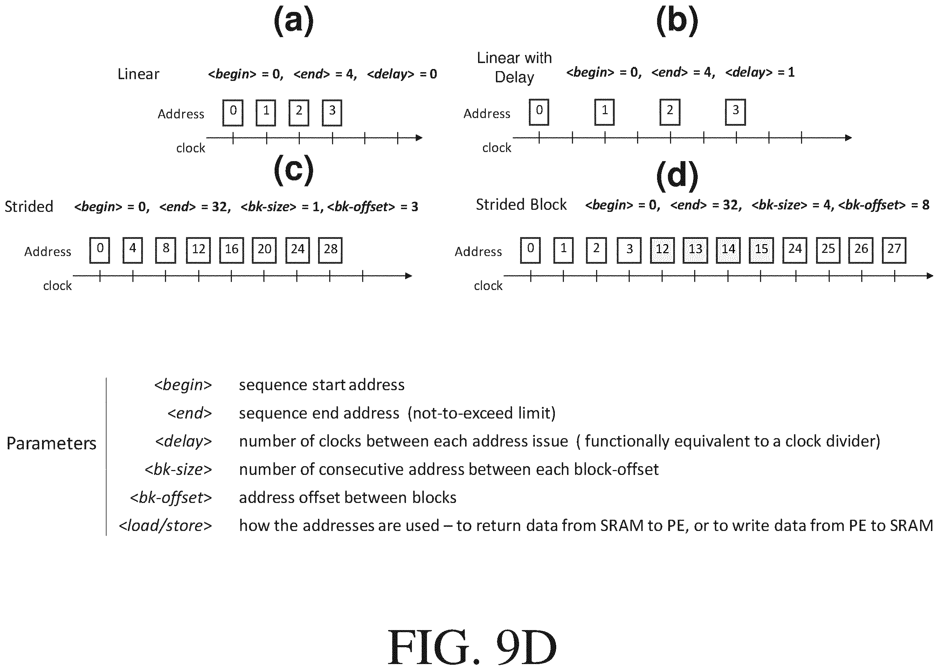

In one or more embodiments, foreground instructions include: load or store register file (load taken from mesh port) and load or store SRAM. For the load/store register file, the opcode is a load/store register entry, the address is the RF address, and data is for the store. The load or store SRAM instruction may include an opcode (load/store SRAM), with an address (SRAM address), data (for store). The background instructions may include: DMA access load/store (see, e.g., FIG. 9D) and a flash instruction. The DMA access load/store includes a linear and strided configuration. The flash instruction includes an opcode to indicate flash from RF to shadow buffer or shadow buffer to RF, or swap.

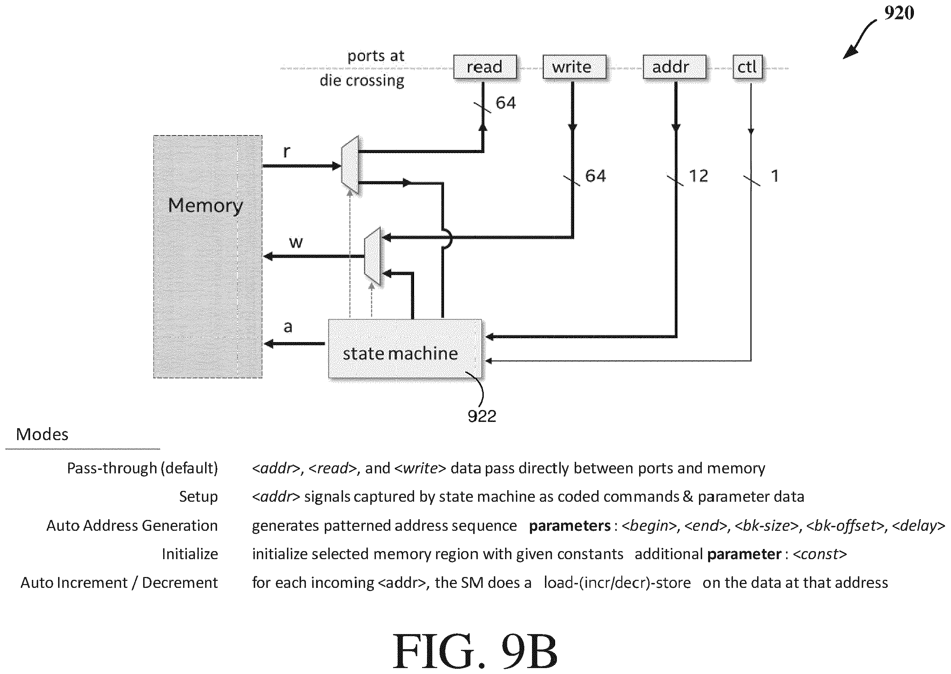

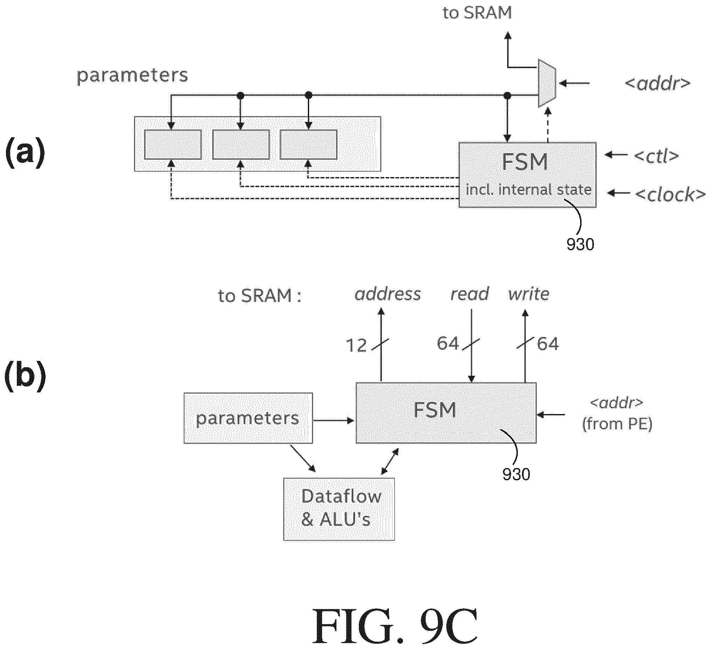

FIGs. 9B, 9C, and 9D illustrate further details regarding the system of FIG. 9A, according to some embodiments. More particularly, FIG. 9B illustrates a block diagram for a system 920 for address generation and a compute configuration, according to an embodiment. System 920 may employ a fire and forget approach for automation of repetitive SRAM operations. For example, a small amount of arithmetic logic and parameter storage controlled by state machine 922 may be utilized. Offloads of PE compute paths may be accomplished by moving address generation and simple arithmetic to the SRAM. In some embodiments, five modes may be supported. Mode selection may be done via descriptors coded onto address line and flagged with a control bit.

As shown in FIG. 9B, the five modes may include: pass-through (which may be a default mode), setup, auto address generation, initialize, and auto increment/decrement. Sample details for each of these modes is illustrated in FIG. 9B according to some embodiments.

FIG. 9C illustrates sample details regarding mode selection and some operations of the system, according to some embodiments. Data on the (e.g., 12-bit) address ("<addr>") lines can be captured by a Finite State Machine (FSM) 930 and interpreted as commands to the state machine.

FIG. 9C (a) shows the signal flow to setup the DMA engine. A Very Long Instruction Word (VLIW) may select the mode shown in FIG. 9C (a). In an embodiment, the PE sends mode-specific parameter data on <addr> lines (where <addr> lines to SRAM is disabled). Once the setup operations complete, mode execution can start (e.g., on assertion of <run> command).

FIG. 9C (b) shows the signal flow in operation. Access to SRAM read/write ports may be controlled by the FSM 930. In an embodiment, PE controls operation via four commands: (1) reset: immediate return to default pass-through mode; (2) run: selected mode becomes active; (3) pause: operation is frozen and state is maintained; and/or (4) resume: continue from paused state.

FIG. 9D illustrates sample sequences for generating patterned address sequences, including linear (a), linear with delay (b), strided (c), and strided block (d) address sequences. As shown, a linear address sequence (a) may utilize begin, end, and delay values and may have no gaps if the delay is zero or consistent gaps per the delay value for a linear with delay sequence (b). A strided address sequence (c) may utilize begin, end, block ("bk") size, and block offset. As a result, the address sequence may space the addresses based on both the block size and block offset as shown. A strided block (d) may also utilize the block size and block offset values but the block size is a value other than one used by a strided (c) sequence.

As shown on the bottom portion of FIG. 9D, the parameters used for the automated generation of address sequences may include: begin, end, delay, block size, block offset, and load/store. As discussed before, these parameters may be used for each address sequence as illustrated in the sample sequences (a), (b), (c), and (d) of FIG. 9D.

Additionally, some embodiments may be applied in computing systems that include one or more processors (e.g., where the one or more processors may include one or more processor cores), such as those discussed with reference to FIGs. 1 et seq., including for example a desktop computer, a workstation, a computer server, a server blade, or a mobile computing device. The mobile computing device may include a smartphone, tablet, UMPC (Ultra-Mobile Personal Computer), laptop computer, Ultrabook^{™} computing device, wearable devices (such as a smart watch, smart ring, smart bracelet, or smart glasses), etc.

### Instruction Sets

An instruction set may include one or more instruction formats. A given instruction format may define various fields (e.g., number of bits, location of bits) to specify, among other things, the operation to be performed (e.g., opcode) and the operand(s) on which that operation is to be performed and/or other data field(s) (e.g., mask). Some instruction formats are further broken down though the definition of instruction templates (or subformats). For example, the instruction templates of a given instruction format may be defined to have different subsets of the instruction format's fields (the included fields are typically in the same order, but at least some have different bit positions because there are less fields included) and/or defined to have a given field interpreted differently. Thus, each instruction of an ISA is expressed using a given instruction format (and, if defined, in a given one of the instruction templates of that instruction format) and includes fields for specifying the operation and the operands. For example, an exemplary ADD instruction has a specific opcode and an instruction format that includes an opcode field to specify that opcode and operand fields to select operands (source 1/destination and source2); and an occurrence of this ADD instruction in an instruction stream will have specific contents in the operand fields that select specific operands. A set of SIMD extensions referred to as the Advanced Vector Extensions (AVX) (AVX1 and AVX2) and using the Vector Extensions (VEX) coding scheme has been released and/or published (e.g., see Intel® 64 and IA-32 Architectures Software Developer's Manual, September 2014; and see Intel® Advanced Vector Extensions Programming Reference, October 2014).

### Exemplary Instruction Formats

Embodiments of the instruction(s) described herein may be embodied in different formats. Additionally, exemplary systems, architectures, and pipelines are detailed below. Embodiments of the instruction(s) may be executed on such systems, architectures, and pipelines, but are not limited to those detailed.

While embodiments will be described in which the vector friendly instruction format supports the following: a 64 byte vector operand length (or size) with 32 bit (4 byte) or 64 bit (8 byte) data element widths (or sizes) (and thus, a 64 byte vector consists of either 16 doubleword-size elements or alternatively, 8 quadword-size elements); a 64 byte vector operand length (or size) with 16 bit (2 byte) or 8 bit (1 byte) data element widths (or sizes); a 32 byte vector operand length (or size) with 32 bit (4 byte), 64 bit (8 byte), 16 bit (2 byte), or 8 bit (1 byte) data element widths (or sizes); and a 16 byte vector operand length (or size) with 32 bit (4 byte), 64 bit (8 byte), 16 bit (2 byte), or 8 bit (1 byte) data element widths (or sizes); alternative embodiments may support more, less and/or different vector operand sizes (e.g., 256 byte vector operands) with more, less, or different data element widths (e.g., 128 bit (16 byte) data element widths).

FIG. 10A is a block diagram illustrating an exemplary instruction format according to embodiments. FIG. 10A shows an instruction format 1000 that is specific in the sense that it specifies the location, size, interpretation, and order of the fields, as well as values for some of those fields. The instruction format 1000 may be used to extend the x86 instruction set, and thus some of the fields are similar or the same as those used in the existing x86 instruction set and extension thereof (e.g., AVX). This format remains consistent with the prefix encoding field, real opcode byte field, MOD R/M field, SIB field, displacement field, and immediate fields of the existing x86 instruction set with extensions.

EVEX Prefix (Bytes 0-3) 1002 - is encoded in a four-byte form.

Format Field 1082 (EVEX Byte 0, bits [7:0]) - the first byte (EVEX Byte 0) is the format field 1082 and it contains 0x62 (the unique value used for distinguishing the vector friendly instruction format in one embodiment).

The second-fourth bytes (EVEX Bytes 1-3) include a number of bit fields providing specific capability.

REX field 1005 (EVEX Byte 1, bits [7-5]) - consists of a EVEX.R bit field (EVEX Byte 1, bit [7] - R), EVEX.X bit field (EVEX byte 1, bit [6] - X), and 1057BEX byte 1, bit[5] - B). The EVEX.R, EVEX.X, and EVEX.B bit fields provide the same functionality as the corresponding VEX bit fields, and are encoded using 1s complement form, i.e., ZMM0 is encoded as 1111B, ZMM15 is encoded as 0000B. Other fields of the instructions encode the lower three bits of the register indexes as is known in the art (rrr, xxx, and bbb), so that Rrrr, Xxxx, and Bbbb may be formed by adding EVEX.R, EVEX.X, and EVEX.B.

REX' field QAc10 - this is the EVEX.R' bit field (EVEX Byte 1, bit [4] - R') that is used to encode either the upper 16 or lower 16 of the extended 32 register set. In one embodiment, this bit, along with others as indicated below, is stored in bit inverted format to distinguish (in the well-known x86 32-bit mode) from the BOUND instruction, whose real opcode byte is 62, but does not accept in the MOD R/M field (described below) the value of 11 in the MOD field; alternative embodiments do not store this and the other indicated bits below in the inverted format. A value of 1 is used to encode the lower 16 registers. In other words, R'Rrrr is formed by combining EVEX.R', EVEX.R, and the other RRR from other fields.

Opcode map field 1015 (EVEX byte 1, bits [3:0] - mmmm) - its content encodes an implied leading opcode byte (0F, 0F 38, or 0F 3).

Data element width field 1064 (EVEX byte 2, bit [7] - W) - is represented by the notation EVEX.W. EVEX.W is used to define the granularity (size) of the datatype (either 32-bit data elements or 64-bit data elements). This field is optional in the sense that it is not needed if only one data element width is supported and/or data element widths are supported using some aspect of the opcodes.

EVEX.vvvv 1020 (EVEX Byte 2, bits [6:3]-vvvv)- the role of EVEX.vvvv may include the following: 1) EVEX.vvvv encodes the first source register operand, specified in inverted (1s complement) form and is valid for instructions with 2 or more source operands; 2) EVEX.vvvv encodes the destination register operand, specified in 1s complement form for certain vector shifts; or 3) EVEX.vvvv does not encode any operand, the field is reserved and should contain 11 11b. Thus, EVEX.vvvv field 1020 encodes the 4 low-order bits of the first source register specifier stored in inverted (1s complement) form. Depending on the instruction, an extra different EVEX bit field is used to extend the specifier size to 32 registers.

EVEX.U 1068 Class field (EVEX byte 2, bit [2]-U) - If EVEX.U = 0, it indicates class A (support merging-writemasking) or EVEX.U0; if EVEX.U = 1, it indicates class B (support zeroing and merging-writemasking)or EVEX.U1.

Prefix encoding field 1025 (EVEX byte 2, bits [1:0]-pp) - provides additional bits for the base operation field. In addition to providing support for the legacy SSE instructions in the EVEX prefix format, this also has the benefit of compacting the SIMD prefix (rather than requiring a byte to express the SIMD prefix, the EVEX prefix requires only 2 bits). In one embodiment, to support legacy SSE instructions that use a SIMD prefix (66H, F2H, F3H) in both the legacy format and in the EVEX prefix format, these legacy SIMD prefixes are encoded into the SIMD prefix encoding field; and at runtime are expanded into the legacy SIMD prefix prior to being provided to the decoder's PLA (so the PLA can execute both the legacy and EVEX format of these legacy instructions without modification). Although newer instructions could use the EVEX prefix encoding field's content directly as an opcode extension, certain embodiments expand in a similar fashion for consistency but allow for different meanings to be specified by these legacy SIMD prefixes. An alternative embodiment may redesign the PLA to support the 2 bit SIMD prefix encodings, and thus not require the expansion.

Alpha field 1053 (EVEX byte 3, bit [7] - EH; also known as EVEX.EH, EVEX.rs, EVEX.RL, EVEX.writemask control, and EVEX.N; also illustrated with α) - its content distinguishes which one of the different augmentation operation types are to be performed.

Beta field 1055 (EVEX byte 3, bits [6:4]-SSS, also known as EVEX.s2-0, EVEX.r2-0, EVEX.rrl, EVEX.LL0, EVEX.LLB; also illustrated with βββ) - distinguishes which of the operations of a specified type are to be performed.

REX' field 1010 - this is the remainder of the REX' field and is the EVEX.V' bit field (EVEX Byte 3, bit [3] - V') that may be used to encode either the upper 16 or lower 16 of the extended 32 register set. This bit is stored in bit inverted format. A value of 1 is used to encode the lower 16 registers. In other words, V'VVVV is formed by combining EVEX.V', EVEX.vvvv.

Writemask field 1071 (EVEX byte 3, bits [2:0]-kkk) - its content specifies the index of a register in the writemask registers. In one embodiment, the specific value EVEX.kkk=000 has a special behavior implying no writemask is used for the particular instruction (this may be implemented in a variety of ways including the use of a writemask hardwired to all ones or hardware that bypasses the masking hardware). When merging, vector masks allow any set of elements in the destination to be protected from updates during the execution of any operation (specified by the base operation and the augmentation operation); in other one embodiment, preserving the old value of each element of the destination where the corresponding mask bit has a 0. In contrast, when zeroing vector masks allow any set of elements in the destination to be zeroed during the execution of any operation (specified by the base operation and the augmentation operation); in one embodiment, an element of the destination is set to 0 when the corresponding mask bit has a 0 value. A subset of this functionality is the ability to control the vector length of the operation being performed (that is, the span of elements being modified, from the first to the last one); however, it is not necessary that the elements that are modified be consecutive. Thus, the writemask field 1071 allows for partial vector operations, including loads, stores, arithmetic, logical, etc. While embodiments are described in which the writemask field's 1071 content selects one of a number of writemask registers that contains the writemask to be used (and thus the writemask field's 1071 content indirectly identifies that masking to be performed), alternative embodiments instead or additionally allow the mask write field's 1071 content to directly specify the masking to be performed.

Real Opcode Field 1030 (Byte 4) is also known as the opcode byte. Part of the opcode is specified in this field.

MOD R/M Field 1040 (Byte 10) includes MOD field 1042, register index field 1044, and R/M field 1046. The MOD field's 1042 content distinguishes between memory access and non-memory access operations. The role of register index field 1044 can be summarized to two situations: encoding either the destination register operand or a source register operand, or be treated as an opcode extension and not used to encode any instruction operand. The content of register index field 1044, directly or through address generation, specifies the locations of the source and destination operands, be they in registers or in memory. These include a sufficient number of bits to select N registers from a PxQ (e.g., 32x512, 7x128, 32x1024, 64x1024) register file. While in one embodiment N may be up to three sources and one destination register, alternative embodiments may support more or less sources and destination registers (e.g., may support up to two sources where one of these sources also acts as the destination, may support up to three sources where one of these sources also acts as the destination, may support up to two sources and one destination).

The role of R/M field 1046 may include the following: encoding the instruction operand that references a memory address, or encoding either the destination register operand or a source register operand.

Scale, Index, Base (SIB) Byte (Byte 6) - The scale field's 1050 content allows for the scaling of the index field's content for memory address generation (e.g., for address generation that uses 2scale * index + base). SIB.xxx 1054 and SIB.bbb 1056 - the contents of these fields have been previously referred to with regard to the register indexes Xxxx and Bbbb.

Displacement field 1063A (Bytes 7-10) - when MOD field 1042 contains 10, bytes 7-10 are the displacement field 1063A, and it works the same as the legacy 32-bit displacement (disp32) and works at byte granularity. This may be used as part of memory address generation (e.g., for address generation that uses 2scale * index + base + displacement).

Displacement factor field 1063B (Byte 7) - when MOD field 1042 contains 01, byte 7 is the displacement factor field 1063B. The location of this field is that same as that of the legacy x86 instruction set 8-bit displacement (disp8), which works at byte granularity. Since disp8 is sign extended, it can only address between - 128 and 127 bytes offsets; in terms of 64 byte cache lines, disp8 uses 8 bits that can be set to only four really useful values -128, -64, 0, and 64; since a greater range is often needed, disp32 is used; however, disp32 requires 4 bytes. In contrast to disp8 and disp32, the displacement factor field 1063B is a reinterpretation of disp8; when using displacement factor field 1063B, the actual displacement is determined by the content of the displacement factor field multiplied by the size of the memory operand access (N). This type of displacement is referred to as disp8*N. This reduces the average instruction length (a single byte of used for the displacement but with a much greater range). Such compressed displacement is based on the assumption that the effective displacement is multiple of the granularity of the memory access, and hence, the redundant low-order bits of the address offset do not need to be encoded. In other words, the displacement factor field 1063B substitutes the legacy x86 instruction set 8-bit displacement. Thus, the displacement factor field 1063B is encoded the same way as an x86 instruction set 8-bit displacement (so no changes in the ModRM/SIB encoding rules) with the only exception that disp8 is overloaded to disp8*N. In other words, there are no changes in the encoding rules or encoding lengths but only in the interpretation of the displacement value by hardware (which needs to scale the displacement by the size of the memory operand to obtain a byte-wise address offset).

Immediate field 1072 allows for the specification of an immediate. This field is optional in the sense that is it not present in an implementation of the generic vector friendly format that does not support immediate and it is not present in instructions that do not use an immediate.

### Full Opcode Field

FIG. 10B is a block diagram illustrating the fields of the instruction format 1000 that make up the full opcode field 1074 according to one embodiment. Specifically, the full opcode field 1074 includes the format field 1082, the base operation field 1043, and the data element width (W) field 1063. The base operation field 1043 includes the prefix encoding field 1025, the opcode map field 1015, and the real opcode field 1030.

### Register Index Field

FIG. 10C is a block diagram illustrating the fields of the format 1000 that make up the register index field 1045 according to one embodiment. Specifically, the register index field 1045 includes the REX field 1005, the REX' field 1010, the MODR/M.reg field 1044, the MODR/M.r/m field 1046, the VVVV field 1020, xxx field 1054, and the bbb field 1056.

### Augmentation Operation Field

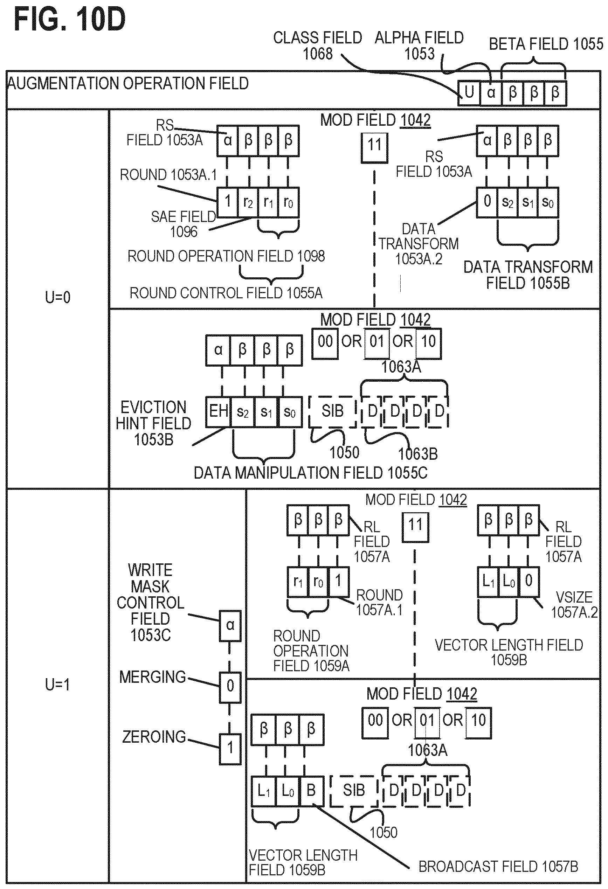

FIG. 10D is a block diagram illustrating the fields of the instruction format 1000 that make up an augmentation operation field according to one embodiment. When the class (U) field 1068 contains 0, it signifies EVEX.U0 (class A 1068A); when it contains 1, it signifies EVEX.U1 (class B 1068B). When U=0 and the MOD field 1042 contains 11 (signifying a no memory access operation), the alpha field 1053 (EVEX byte 3, bit [7] - EH) is interpreted as the rs field 1053A. When the rs field 1053A contains a 1 (round 1053A.1), the beta field 1055 (EVEX byte 3, bits [6:4]- SSS) is interpreted as the round control field 1055A. The round control field 1055A includes a one bit SAE field 1096 and a two bit round operation field 1098. When the rs field 1053A contains a 0 (data transform 1053A.2), the beta field 1055 (EVEX byte 3, bits [6:4]- SSS) is interpreted as a three bit data transform field 1055B. When U=0 and the MOD field 1042 contains 00, 01, or 10 (signifying a memory access operation), the alpha field 1053 (EVEX byte 3, bit [7] - EH) is interpreted as the eviction hint (EH) field 1053B and the beta field 1055 (EVEX byte 3, bits [6:4]- SSS) is interpreted as a three bit data manipulation field 1055C.

When U=1, the alpha field 1053 (EVEX byte 3, bit [7] - EH) is interpreted as the writemask control (Z) field 1053C. When U=1 and the MOD field 1042 contains 11 (signifying a no memory access operation), part of the beta field 1055 (EVEX byte 3, bit [4]- S0) is interpreted as the RL field 1057A; when it contains a 1 (round 1057A.1) the rest of the beta field 1055 (EVEX byte 3, bit [6-5]- S2-1) is interpreted as the round operation field 1059A, while when the RL field 1057A contains a 0 (VSIZE 1057.A2) the rest of the beta field 1055 (EVEX byte 3, bit [6-5]- S2-1) is interpreted as the vector length field 1059B (EVEX byte 3, bit [6-5]- L1-0). When U=1 and the MOD field 1042 contains 00, 01, or 10 (signifying a memory access operation), the beta field 1055 (EVEX byte 3, bits [6:4]- SSS) is interpreted as the vector length field 1059B (EVEX byte 3, bit [6-5]- L1-0) and the broadcast field 1057B (EVEX byte 3, bit [4]- B).

### Exemplary Register Architecture

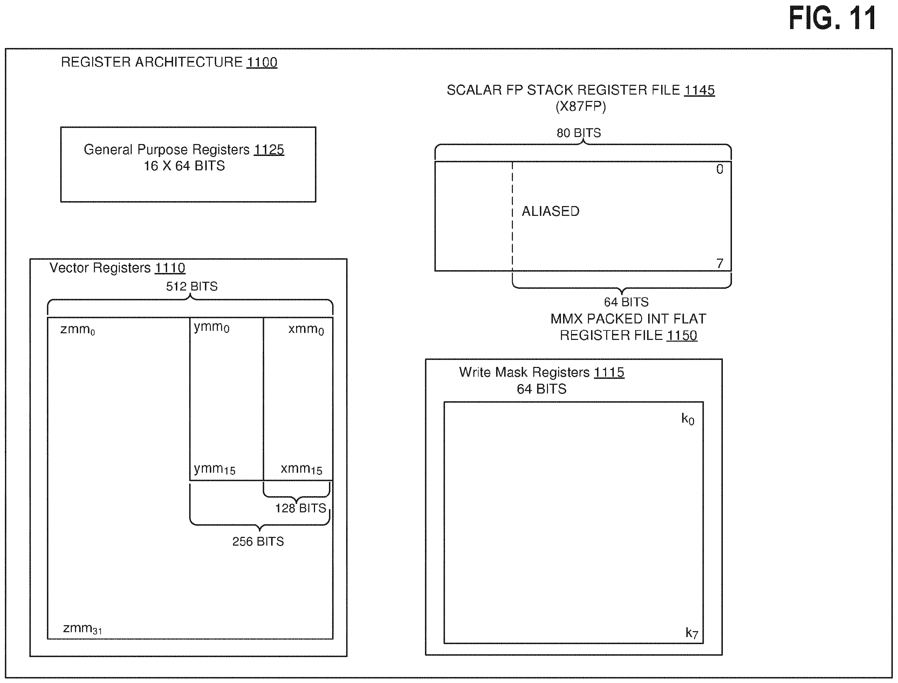

FIG. 11 is a block diagram of a register architecture 1100 according to one embodiment. In the embodiment illustrated, there are 32 vector registers 1110 that are 512 bits wide; these registers are referenced as ZMM0 through ZMM31. The lower order 256 bits of the lower 16 ZMM registers are overlaid on registers YMM0-16. The lower order 128 bits of the lower 16 ZMM registers (the lower order 128 bits of the YMM registers) are overlaid on registers XMM0-15. In other words, the vector length field 459B selects between a maximum length and one or more other shorter lengths, where each such shorter length is half the length of the preceding length; and instructions templates without the vector length field 459B operate on the maximum vector length. Further, in one embodiment, the class B instruction templates of the instruction format 400 operate on packed or scalar single/double-precision floating point data and packed or scalar integer data. Scalar operations are operations performed on the lowest order data element position in a ZMM/YMM/XMM register; the higher order data element positions are either left the same as they were prior to the instruction or zeroed depending on the embodiment.

Writemask registers 1115 - in the embodiment illustrated, there are 8 writemask registers (k0 through k7), each 114 bits in size. In an alternate embodiment, the writemask registers 1115 are 16 bits in size. In some embodiments, the vector mask register k0 cannot be used as a writemask; when the encoding that would normally indicate k0 is used for a writemask, it selects a hardwired writemask of 0xFFFF, effectively disabling writemasking for that instruction.

General-purpose registers 1125 - in the embodiment illustrated, there are sixteen 114-bit general-purpose registers that are used along with the existing x86 addressing modes to address memory operands. These registers are referenced by the names RAX, RBX, RCX, RDX, RBP, RSI, RDI, RSP, and R8 through R15.

Scalar floating point stack register file (x87 stack) 1145, on which is aliased the MMX packed integer flat register file 1150 - in the embodiment illustrated, the x87 stack is an eight-element stack used to perform scalar floating-point operations on 32/64/80-bit floating point data using the x87 instruction set extension; while the MMX registers are used to perform operations on 114-bit packed integer data, as well as to hold operands for some operations performed between the MMX and XMM registers.

Alternative embodiments may use wider or narrower registers. Additionally, alternative embodiments may use more, less, or different register files and registers.

### Exemplary Core Architectures, Processors, and Computer Architectures

Processor cores may be implemented in different ways, for different purposes, and in different processors. For instance, implementations of such cores may include: 1) a general purpose in-order core intended for general-purpose computing; 2) a high-performance general purpose out-of-order core intended for general-purpose computing; 3) a special purpose core intended primarily for graphics and/or scientific (throughput) computing. Implementations of different processors may include: 1) a CPU (Central Processing Unit) including one or more general purpose in-order cores intended for general-purpose computing and/or one or more general purpose out-of-order cores intended for general-purpose computing; and 2) a coprocessor including one or more special purpose cores intended primarily for graphics and/or scientific (throughput). Such different processors lead to different computer system architectures, which may include: 1) the coprocessor on a separate chip from the CPU; 2) the coprocessor on a separate die in the same package as a CPU; 3) the coprocessor on the same die as a CPU (in which case, such a coprocessor is sometimes referred to as special purpose logic, such as integrated graphics and/or scientific (throughput) logic, or as special purpose cores); and 4) a system on a chip that may include on the same die the described CPU (sometimes referred to as the application core(s) or application processor(s)), the above described coprocessor, and additional functionality. Exemplary core architectures are described next, followed by descriptions of exemplary processors and computer architectures.

### Exemplary Core Architectures

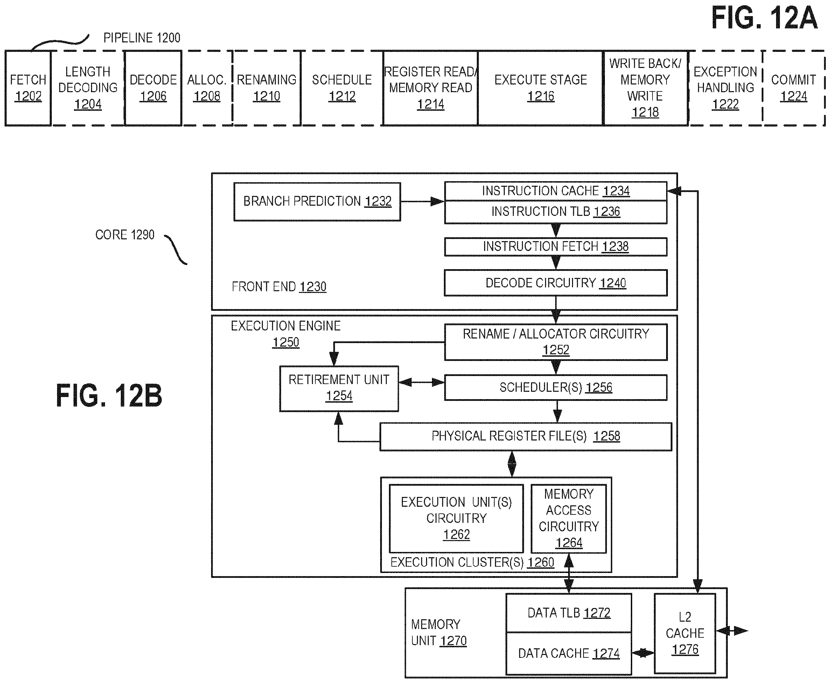

FIG. 12A is a block diagram illustrating both an exemplary in-order pipeline and an exemplary register renaming, out-of-order issue/execution pipeline according to embodiments. FIG. 12B is a block diagram illustrating both an exemplary embodiment of an in-order architecture core and an exemplary register renaming, out-of-order issue/execution architecture core to be included in a processor according to embodiments. The solid lined boxes in FIGS. 12A-B illustrate the in-order pipeline and in-order core, while the optional addition of the dashed lined boxes illustrates the register renaming, out-of-order issue/execution pipeline and core. Given that the in-order aspect is a subset of the out-of-order aspect, the out-of-order aspect will be described.

In FIG. 12A, a processor pipeline 1200 includes a fetch stage 1202, a length decode stage 1204, a decode stage 1206, an allocation stage 1208, a renaming stage 1210, a scheduling (also known as a dispatch or issue) stage 1212, a register read/memory read stage 1214, an execute stage 1216, a write back/memory write stage 1218, an exception handling stage 1222, and a commit stage 1224.

FIG. 12B shows processor core 1290 including a front end unit 1230 coupled to an execution engine unit 1250, and both are coupled to a memory unit 1270. The core 1290 may be a reduced instruction set computing (RISC) core, a complex instruction set computing (CISC) core, a very long instruction word (VLIW) core, or a hybrid or alternative core type. As yet another option, the core 1290 may be a special-purpose core, such as, for example, a network or communication core, compression engine, coprocessor core, general purpose computing graphics processing unit (GPGPU) core, graphics core, or the like.

The front end unit 1230 includes a branch prediction unit 1232 coupled to an instruction cache unit 1234, which is coupled to an instruction translation lookaside buffer (TLB) 1236, which is coupled to an instruction fetch unit 1238, which is coupled to a decode unit 1240. The decode unit 1240 (or decoder) may decode instructions, and generate as an output one or more micro-operations, micro-code entry points, microinstructions, other instructions, or other control signals, which are decoded from, or which otherwise reflect, or are derived from, the original instructions. The decode unit 1240 may be implemented using various different mechanisms. Examples of suitable mechanisms include, but are not limited to, look-up tables, hardware implementations, programmable logic arrays (PLAs), microcode read only memories (ROMs), etc. In one embodiment, the core 1290 includes a microcode ROM or other medium that stores microcode for certain macroinstructions (e.g., in decode unit 1240 or otherwise within the front end unit 1230). The decode unit 1240 is coupled to a rename/allocator unit 1252 in the execution engine unit 1250.

The execution engine unit 1250 includes the rename/allocator unit 1252 coupled to a retirement unit 1254 and a set of one or more scheduler unit(s) 1256. The scheduler unit(s) 1256 represents any number of different schedulers, including reservations stations, central instruction window, etc. The scheduler unit(s) 1256 is coupled to the physical register file(s) unit(s) 1258. Each of the physical register file(s) units 1258 represents one or more physical register files, different ones of which store one or more different data types, such as scalar integer, scalar floating point, packed integer, packed floating point, vector integer, vector floating point" status (e.g., an instruction pointer that is the address of the next instruction to be executed), etc. In one embodiment, the physical register file(s) unit 1258 comprises a vector registers unit, a writemask registers unit, and a scalar registers unit. These register units may provide architectural vector registers, vector mask registers, and general purpose registers. The physical register file(s) unit(s) 1258 is overlapped by the retirement unit 1254 to illustrate various ways in which register renaming and out-of-order execution may be implemented (e.g., using a reorder buffer(s) and a retirement register file(s); using a future file(s), a history buffer(s), and a retirement register file(s); using a register maps and a pool of registers; etc.). The retirement unit 1254 and the physical register file(s) unit(s) 1258 are coupled to the execution cluster(s) 1260. The execution cluster(s) 1260 includes a set of one or more execution units 1262 and a set of one or more memory access units 1264. The execution units 1262 may perform various operations (e.g., shifts, addition, subtraction, multiplication) and on various types of data (e.g., scalar floating point, packed integer, packed floating point, vector integer, vector floating point). While some embodiments may include a number of execution units dedicated to specific functions or sets of functions, other embodiments may include only one execution unit or multiple execution units that all perform all functions. The scheduler unit(s) 1256, physical register file(s) unit(s) 1258, and execution cluster(s) 1260 are shown as being possibly plural because certain embodiments create separate pipelines for certain types of data/operations (e.g., a scalar integer pipeline, a scalar floating point/packed integer/packed floating point/vector integer/vector floating point pipeline, and/or a memory access pipeline that each have their own scheduler unit, physical register file(s) unit, and/or execution cluster - and in the case of a separate memory access pipeline, certain embodiments are implemented in which only the execution cluster of this pipeline has the memory access unit(s) 1264). It should also be understood that where separate pipelines are used, one or more of these pipelines may be out-of-order issue/execution and the rest in-order.

The set of memory access units 1264 is coupled to the memory unit 1270, which includes a data TLB unit 1272 coupled to a data cache unit 1274 coupled to a level 2 (L2) cache unit 1276. In one exemplary embodiment, the memory access units 1264 may include a load unit, a store address unit, and a store data unit, each of which is coupled to the data TLB unit 1272 in the memory unit 1270. The instruction cache unit 1234 is further coupled to a level 2 (L2) cache unit 1276 in the memory unit 1270. The L2 cache unit 1276 is coupled to one or more other levels of cache and eventually to a main memory.

By way of example, the exemplary register renaming, out-of-order issue/execution core architecture may implement the pipeline 1200 as follows: 1) the instruction fetch 1238 performs the fetch and length decoding stages 1202 and 1204; 2) the decode unit 1240 performs the decode stage 1206; 3) the rename/allocator unit 1252 performs the allocation stage 1208 and renaming stage 1210; 4) the scheduler unit(s) 1256 performs the schedule stage 1212; 5) the physical register file(s) unit(s) 1258 and the memory unit 1270 perform the register read/memory read stage 1214; the execution cluster 1260 perform the execute stage 1216; 6) the memory unit 1270 and the physical register file(s) unit(s) 1258 perform the write back/memory write stage 1218; 12) various units may be involved in the exception handling stage 1222; and 8) the retirement unit 1254 and the physical register file(s) unit(s) 1258 perform the commit stage 1224.

The core 1290 may support one or more instructions sets (e.g., the x86 instruction set (with some extensions that have been added with newer versions); the MIPS instruction set of MIPS Technologies of Sunnyvale, CA; the ARM instruction set (with optional additional extensions such as NEON) of ARM Holdings of Sunnyvale, CA), including the instruction(s) described herein. In one embodiment, the core 1290 includes logic to support a packed data instruction set extension (e.g., AVX1, AVX2), thereby allowing the operations used by many multimedia applications to be performed using packed data.

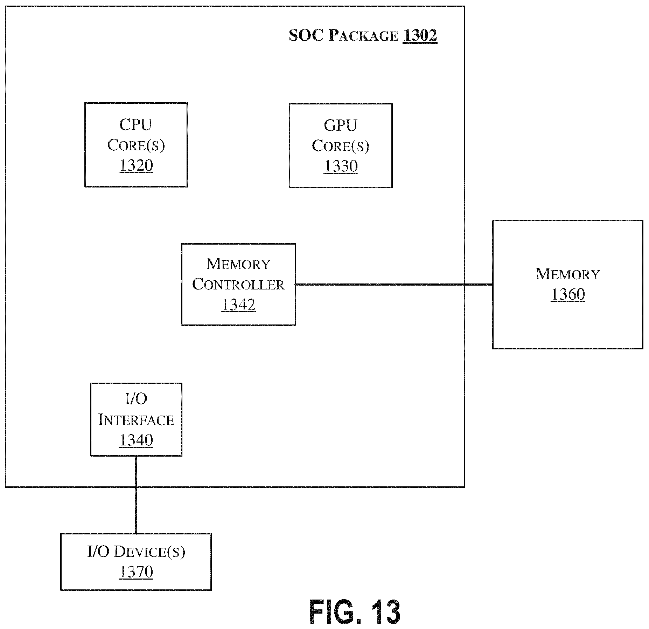

FIG. 13 illustrates a block diagram of an SOC package in accordance with an embodiment. As illustrated in FIG. 13, SOC 1302 includes one or more Central Processing Unit (CPU) cores 1320, one or more Graphics Processor Unit (GPU) cores 1330, an Input/Output (I/O) interface 1340, and a memory controller 1342. Various components of the SOC package 1302 may be coupled to an interconnect or bus such as discussed herein with reference to the other figures. Also, the SOC package 1302 may include more or less components, such as those discussed herein with reference to the other figures. Further, each component of the SOC package 1302 may include one or more other components, e.g., as discussed with reference to the other figures herein. In one embodiment, SOC package 1302 (and its components) is provided on one or more Integrated Circuit (IC) die, e.g., which are packaged into a single semiconductor device.

As illustrated in FIG. 13, SOC package 1302 is coupled to a memory 1360 via the memory controller 1342. In an embodiment, the memory 1360 (or a portion of it) can be integrated on the SOC package 1302.

The I/O interface 1340 may be coupled to one or more I/O devices 1370, e.g., via an interconnect and/or bus such as discussed herein with reference to other figures. I/O device(s) 1370 may include one or more of a keyboard, a mouse, a touchpad, a display, an image/video capture device (such as a camera or camcorder/video recorder), a touch screen, a speaker, or the like.

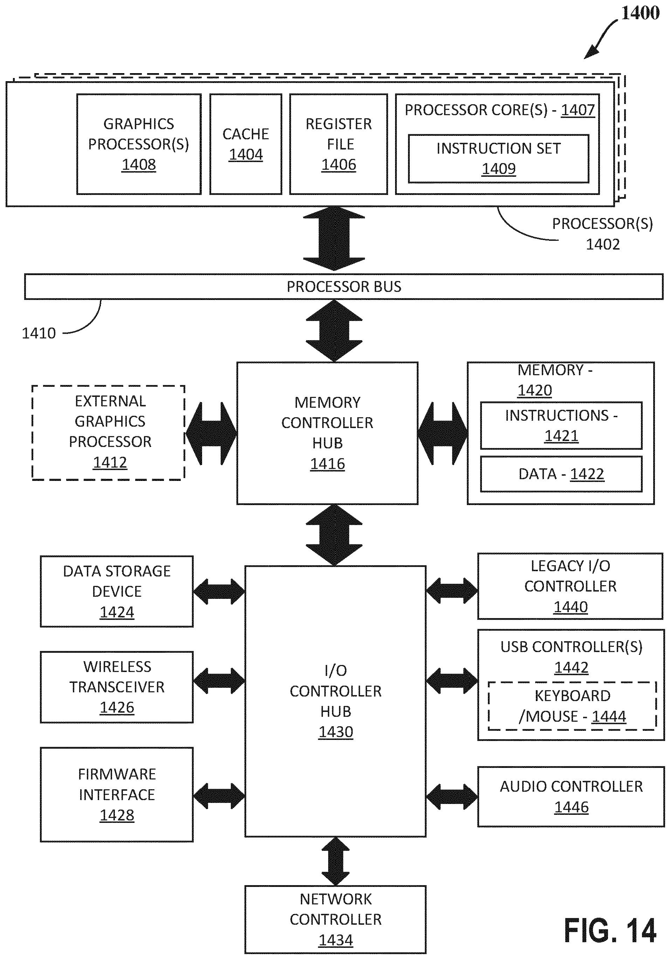

FIG. 14 is a block diagram of a processing system 1400, according to an embodiment. In various embodiments the system 1400 includes one or more processors 1402 and one or more graphics processors 1408, and may be a single processor desktop system, a multiprocessor workstation system, or a server system having a large number of processors 1402 or processor cores 1407. In on embodiment, the system 1400 is a processing platform incorporated within a system-on-a-chip (SoC or SOC) integrated circuit for use in mobile, handheld, or embedded devices.

An embodiment of system 1400 can include, or be incorporated within a server-based gaming platform, a game console, including a game and media console, a mobile gaming console, a handheld game console, or an online game console. In some embodiments system 1400 is a mobile phone, smart phone, tablet computing device or mobile Internet device. Data processing system 1400 can also include, couple with, or be integrated within a wearable device, such as a smart watch wearable device, smart eyewear device, augmented reality device, or virtual reality device. In some embodiments, data processing system 1400 is a television or set top box device having one or more processors 1402 and a graphical interface generated by one or more graphics processors 1408.

In some embodiments, the one or more processors 1402 each include one or more processor cores 1407 to process instructions which, when executed, perform operations for system and user software. In some embodiments, each of the one or more processor cores 1407 is configured to process a specific instruction set 1409. In some embodiments, instruction set 1409 may facilitate Complex Instruction Set Computing (CISC), Reduced Instruction Set Computing (RISC), or computing via a Very Long Instruction Word (VLIW). Multiple processor cores 1407 may each process a different instruction set 1409, which may include instructions to facilitate the emulation of other instruction sets. Processor core 1407 may also include other processing devices, such a Digital Signal Processor (DSP).

In some embodiments, the processor 1402 includes cache memory 1404. Depending on the architecture, the processor 1402 can have a single internal cache or multiple levels of internal cache. In some embodiments, the cache memory is shared among various components of the processor 1402. In some embodiments, the processor 1402 also uses an external cache (e.g., a Level-3 (L3) cache or Last Level Cache (LLC)) (not shown), which may be shared among processor cores 1407 using known cache coherency techniques. A register file 1406 is additionally included in processor 1402 which may include different types of registers for storing different types of data (e.g., integer registers, floating point registers, status registers, and an instruction pointer register). Some registers may be general-purpose registers, while other registers may be specific to the design of the processor 1402.

In some embodiments, processor 1402 is coupled to a processor bus 1410 to transmit communication signals such as address, data, or control signals between processor 1402 and other components in system 1400. In one embodiment the system 1400 uses an exemplary `hub' system architecture, including a memory controller hub 1416 and an Input Output (I/O) controller hub 1430. A memory controller hub 1416 facilitates communication between a memory device and other components of system 1400, while an I/O Controller Hub (ICH) 1430 provides connections to I/O devices via a local I/O bus. In one embodiment, the logic of the memory controller hub 1416 is integrated within the processor.

Memory device 1420 can be a dynamic random access memory (DRAM) device, a static random access memory (SRAM) device, flash memory device, phase-change memory device, or some other memory device having suitable performance to serve as process memory. In one embodiment the memory device 1420 can operate as system memory for the system 1400, to store data 1422 and instructions 1421 for use when the one or more processors 1402 executes an application or process. Memory controller hub 1416 also couples with an optional external graphics processor 1412, which may communicate with the one or more graphics processors 1408 in processors 1402 to perform graphics and media operations.

In some embodiments, ICH 1430 enables peripherals to connect to memory device 1420 and processor 1402 via a high-speed I/O bus. The I/O peripherals include, but are not limited to, an audio controller 1446, a firmware interface 1428, a wireless transceiver 1426 (e.g., Wi-Fi, Bluetooth), a data storage device 1424 (e.g., hard disk drive, flash memory, etc.), and a legacy I/O controller 1440 for coupling legacy (e.g., Personal System 2 (PS/2)) devices to the system. One or more Universal Serial Bus (USB) controllers 1442 connect input devices, such as keyboard and mouse 1444 combinations. A network controller 1434 may also couple to ICH 1430. In some embodiments, a high-performance network controller (not shown) couples to processor bus 1410. It will be appreciated that the system 1400 shown is exemplary and not limiting, as other types of data processing systems that are differently configured may also be used. For example, the I/O controller hub 1430 may be integrated within the one or more processor 1402, or the memory controller hub 1416 and I/O controller hub 1430 may be integrated into a discreet external graphics processor, such as the external graphics processor 1412.

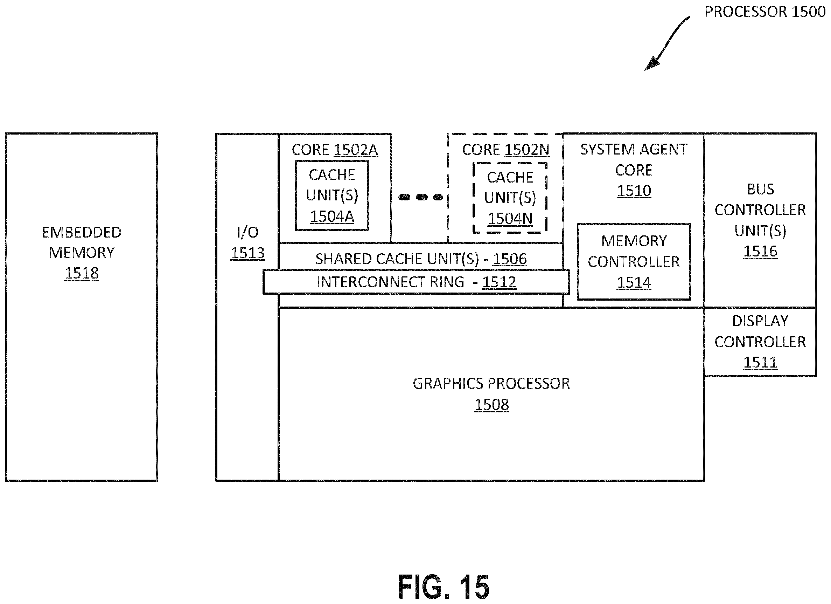

FIG. 15 is a block diagram of an embodiment of a processor 1500 having one or more processor cores 1502A to 1502N, an integrated memory controller 1514, and an integrated graphics processor 1508. Those elements of FIG. 15 having the same reference numbers (or names) as the elements of any other figure herein can operate or function in any manner similar to that described elsewhere herein, but are not limited to such. Processor 1500 can include additional cores up to and including additional core 1502N represented by the dashed lined boxes. Each of processor cores 1502A to 1502N includes one or more internal cache units 1504A to 1504N. In some embodiments each processor core also has access to one or more shared cached units 1506.

The internal cache units 1504A to 1504N and shared cache units 1506 represent a cache memory hierarchy within the processor 1500. The cache memory hierarchy may include at least one level of instruction and data cache within each processor core and one or more levels of shared mid-level cache, such as a Level 2 (L2), Level 3 (L3), Level 4 (L4), or other levels of cache, where the highest level of cache before external memory is classified as the LLC. In some embodiments, cache coherency logic maintains coherency between the various cache units 1506 and 1504A to 1504N.

In some embodiments, processor 1500 may also include a set of one or more bus controller units 1516 and a system agent core 1510. The one or more bus controller units 1516 manage a set of peripheral buses, such as one or more Peripheral Component Interconnect buses (e.g., PCI, PCI Express). System agent core 1510 provides management functionality for the various processor components. In some embodiments, system agent core 1510 includes one or more integrated memory controllers 1514 to manage access to various external memory devices (not shown).

In some embodiments, one or more of the processor cores 1502A to 1502N include support for simultaneous multi-threading. In such embodiment, the system agent core 1510 includes components for coordinating and operating cores 1502A to 1502N during multi-threaded processing. System agent core 1510 may additionally include a power control unit (PCU), which includes logic and components to regulate the power state of processor cores 1502A to 1502N and graphics processor 1508.

In some embodiments, processor 1500 additionally includes graphics processor 1508 to execute graphics processing operations. In some embodiments, the graphics processor 1508 couples with the set of shared cache units 1506, and the system agent core 1510, including the one or more integrated memory controllers 1514. In some embodiments, a display controller 1511 is coupled with the graphics processor 1508 to drive graphics processor output to one or more coupled displays. In some embodiments, display controller 1511 may be a separate module coupled with the graphics processor via at least one interconnect, or may be integrated within the graphics processor 1508 or system agent core 1510.

In some embodiments, a ring-based interconnect unit 1512 is used to couple the internal components of the processor 1500. However, an alternative interconnect unit may be used, such as a point-to-point interconnect, a switched interconnect, or other techniques, including techniques well known in the art. In some embodiments, graphics processor 1508 couples with the ring interconnect 1512 via an I/O link 1513.

The exemplary I/O link 1513 represents at least one of multiple varieties of I/O interconnects, including an on package I/O interconnect which facilitates communication between various processor components and a high-performance embedded memory module 1518, such as an eDRAM (or embedded DRAM) module. In some embodiments, each of the processor cores 1502 to 1502N and graphics processor 1508 use embedded memory modules 1518 as a shared Last Level Cache.

In some embodiments, processor cores 1502A to 1502N are homogenous cores executing the same instruction set architecture. In another embodiment, processor cores 1502A to 1502N are heterogeneous in terms of instruction set architecture (ISA), where one or more of processor cores 1502A to 1502N execute a first instruction set, while at least one of the other cores executes a subset of the first instruction set or a different instruction set. In one embodiment processor cores 1502A to 1502N are heterogeneous in terms of micro architecture, where one or more cores having a relatively higher power consumption couple with one or more power cores having a lower power consumption. Additionally, processor 1500 can be implemented on one or more chips or as an SoC integrated circuit having the illustrated components, in addition to other components.

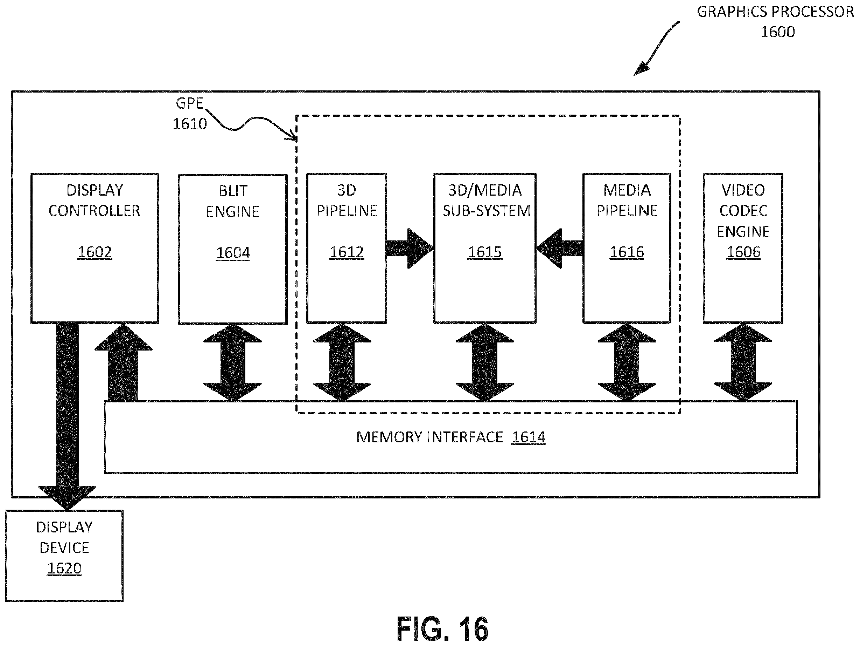

FIG. 16 is a block diagram of a graphics processor 1600, which may be a discrete graphics processing unit, or may be a graphics processor integrated with a plurality of processing cores. In some embodiments, the graphics processor communicates via a memory mapped I/O interface to registers on the graphics processor and with commands placed into the processor memory. In some embodiments, graphics processor 1600 includes a memory interface 1614 to access memory. Memory interface 1614 can be an interface to local memory, one or more internal caches, one or more shared external caches, and/or to system memory.

In some embodiments, graphics processor 1600 also includes a display controller 1602 to drive display output data to a display device 1620. Display controller 1602 includes hardware for one or more overlay planes for the display and composition of multiple layers of video or user interface elements. In some embodiments, graphics processor 1600 includes a video codec engine 1606 to encode, decode, or transcode media to, from, or between one or more media encoding formats, including, but not limited to Moving Picture Experts Group (MPEG) formats such as MPEG-2, Advanced Video Coding (AVC) formats such as H.264/MPEG-4 AVC, as well as the Society of Motion Picture & Television Engineers (SMPTE) 321M/VC-1, and Joint Photographic Experts Group (JPEG) formats such as JPEG, and Motion JPEG (MJPEG) formats.

In some embodiments, graphics processor 1600 includes a block image transfer (BLIT) engine 1604 to perform two-dimensional (2D) rasterizer operations including, for example, bit-boundary block transfers. However, in one embodiment, 3D graphics operations are performed using one or more components of graphics processing engine (GPE) 1610. In some embodiments, graphics processing engine 1610 is a compute engine for performing graphics operations, including three-dimensional (3D) graphics operations and media operations.

In some embodiments, GPE 1610 includes a 3D pipeline 1612 for performing 3D operations, such as rendering three-dimensional images and scenes using processing functions that act upon 3D primitive shapes (e.g., rectangle, triangle, etc.). The 3D pipeline 1612 includes programmable and fixed function elements that perform various tasks within the element and/or spawn execution threads to a 3D/Media sub-system 1615. While 3D pipeline 1612 can be used to perform media operations, an embodiment of GPE 1610 also includes a media pipeline 1616 that is specifically used to perform media operations, such as video post-processing and image enhancement.

In some embodiments, media pipeline 1616 includes fixed function or programmable logic units to perform one or more specialized media operations, such as video decode acceleration, video de-interlacing, and video encode acceleration in place of, or on behalf of video codec engine 1606. In some embodiments, media pipeline 1616 additionally includes a thread spawning unit to spawn threads for execution on 3D/Media sub-system 1615. The spawned threads perform computations for the media operations on one or more graphics execution units included in 3D/Media sub-system 1615.

In some embodiments, 3D/Media subsystem 1615 includes logic for executing threads spawned by 3D pipeline 1612 and media pipeline 1616. In one embodiment, the pipelines send thread execution requests to 3D/Media subsystem 1615, which includes thread dispatch logic for arbitrating and dispatching the various requests to available thread execution resources. The execution resources include an array of graphics execution units to process the 3D and media threads. In some embodiments, 3D/Media subsystem 1615 includes one or more internal caches for thread instructions and data. In some embodiments, the subsystem also includes shared memory, including registers and addressable memory, to share data between threads and to store output data.

In the following description, numerous specific details are set forth to provide a more thorough understanding. However, it will be apparent to one of skill in the art that the embodiments described herein may be practiced without one or more of these specific details. In other instances, well-known features have not been described to avoid obscuring the details of the present embodiments.

The following examples pertain to further embodiments. Example 1 includes an apparatus comprising: a register file having a plurality of register file cells, each of the register file cells to include a register file entry and a shadow buffer; and logic circuitry to cause storage of input data to the shadow buffer, while data stored in the register file entry is to be accessible to perform one or more operations. Example 2 includes the apparatus of example 1, wherein contents of selected register file entries and their corresponding shadow buffers are to be exchanged simultaneously. Example 3 includes the apparatus of example 1, wherein contents of selected register file entries and their corresponding shadow buffers are to be exchanged in a single clock cycle. Example 4 includes the apparatus of example 1, wherein contents of selected register file entries and their corresponding shadow buffers are to be overwritten simultaneously. Example 5 includes the apparatus of example 1, wherein the register file is to be partitioned into a plurality of domains, wherein each domain is to support a selectable mode for latching and/or transport of data. Example 6 includes the apparatus of example 1, wherein the shadow buffer is capable to load from one or more data streams and/or to write to the one or more data streams. Example 7 includes the apparatus of example 1, wherein a processor, having one or more processor cores, is to access the data stored in the register file entry to perform the one or more operations. Example 8 includes the apparatus of example 1, wherein the one or more operations comprise a load operation and/or a store operation. Example 9 includes the apparatus of example 1, wherein the input data is to be read from a backing storage. Example 10 includes the apparatus of example 9, wherein the backing storage comprises Static Random-Access Memory (SRAM). Example 11 includes the apparatus of example 9, wherein a working data set is to be subdivided into a plurality of data blocks stored in the backing storage. Example 12 includes the apparatus of example 9, wherein the backing storage and the plurality of register file cells are to communicate via a lower bandwidth interconnect than an interconnect coupled between a processor and the plurality of register file cells. Example 13 includes the apparatus of example 9, wherein a die stack comprises a separate die for the backing storage than a die for the plurality of register file cells. Example 14 includes the apparatus of example 9, wherein the register file has a functional capacity which can be as large as a capacity of the backing storage. Example 15 includes the apparatus of example 1, wherein the register file entry and the shadow buffer have a same capacity. Example 16 includes the apparatus of example 1, wherein the shadow buffer comprises at least one of a latch and a flip-flop. Example 17 includes the apparatus of example 1, wherein a processor, having one or more processor cores, comprises the logic circuitry. Example 18 includes the apparatus of example 17, wherein the processor comprises a graphics processing unit and/or a general-purpose processor. Example 19 includes an apparatus comprising: decode circuitry to decode an instruction having a field for an operand value; and execution circuitry to execute the decoded instruction to perform one or more operations in accordance with the operand value, wherein the one or more operations cause storage of input data to a shadow buffer of a register file cell, while data stored in a register file entry of the register file cell is to be accessible to execute one or more tasks. Example 20 includes the apparatus of example 19, wherein a processor, having one or more processor cores, is to access the data stored in the register file entry to perform the one or more tasks. Example 21 includes the apparatus of example 19, wherein a register file comprises a plurality of the register file cells, wherein contents of selected register file entries of the register file and their corresponding shadow buffers are to be at least one of exchanged and overwritten in a single clock cycle.

Example 22 includes one or more non-transitory computer-readable media comprising one or more instructions that when executed on a processor configure the processor to perform one or more operations to cause: a register file, having a plurality of register file cells, to store data, each of the register file cells to include a register file entry and a shadow buffer; and logic circuitry to cause storage of input data to the shadow buffer, while data stored in the register file entry is to be accessible to perform one or more operations. Example 23 includes the one or more non-transitory computer-readable media of example 22, further comprising one or more instructions that when executed on the processor configure the processor to perform one or more operations to cause contents of selected register file entries and their corresponding shadow buffers to be exchanged simultaneously. Example 24 includes the one or more non-transitory computer-readable media of example 22, further comprising one or more instructions that when executed on the processor configure the processor to perform one or more operations to cause contents of selected register file entries and their corresponding shadow buffers to be exchanged in a single clock cycle.

Example 25 includes an apparatus comprising means to perform a method as set forth in any preceding example. Example 26 includes machine-readable storage including machine-readable instructions, when executed, to implement a method or realize an apparatus as set forth in any preceding example.

In various embodiments, one or more operations discussed with reference to Figs. 1 et seq. may be performed by one or more components (interchangeably referred to herein as "logic") discussed with reference to any of the figures.

In various embodiments, the operations discussed herein, e.g., with reference to Figs. 1 et seq., may be implemented as hardware (e.g., logic circuitry), software, firmware, or combinations thereof, which may be provided as a computer program product, e.g., including one or more tangible (e.g., non-transitory) machine-readable or computer-readable media having stored thereon instructions (or software procedures) used to program a computer to perform a process discussed herein. The machine-readable medium may include a storage device such as those discussed with respect to the figures.

Additionally, such computer-readable media may be downloaded as a computer program product, wherein the program may be transferred from a remote computer (e.g., a server) to a requesting computer (e.g., a client) by way of data signals provided in a carrier wave or other propagation medium via a communication link (e.g., a bus, a modem, or a network connection).

Reference in the specification to "one embodiment" or "an embodiment" means that a particular feature, structure, and/or characteristic described in connection with the embodiment may be included in at least an implementation. The appearances of the phrase "in one embodiment" in various places in the specification may or may not be all referring to the same embodiment.

Also, in the description and claims, the terms "coupled" and "connected," along with their derivatives, may be used. In some embodiments, "connected" may be used to indicate that two or more elements are in direct physical or electrical contact with each other. "Coupled" may mean that two or more elements are in direct physical or electrical contact. However, "coupled" may also mean that two or more elements may not be in direct contact with each other, but may still cooperate or interact with each other.

Thus, although embodiments have been described in language specific to structural features and/or methodological acts, it is to be understood that claimed subject matter may not be limited to the specific features or acts described. Rather, the specific features and acts are disclosed as sample forms of implementing the claimed subject matter.

## Claims

1. An apparatus comprising:
a register file having a plurality of register file cells, each of the register file cells to include a register file entry and a shadow buffer; and
logic circuitry to cause storage of input data to the shadow buffer, while data stored in the register file entry is to be accessible to perform one or more operations.

2. The apparatus of claim 1, wherein contents of selected register file entries and their corresponding shadow buffers are to be exchanged simultaneously.

3. The apparatus of claim 1, wherein contents of selected register file entries and their corresponding shadow buffers are to be exchanged in a single clock cycle.

4. The apparatus of claim 1, wherein contents of selected register file entries and their corresponding shadow buffers are to be overwritten simultaneously.

5. The apparatus of claim 1, wherein the register file is to be partitioned into a plurality of domains, wherein each domain is to support a selectable mode for latching and/or transport of data.

6. The apparatus of claim 1, wherein the shadow buffer is capable to load from one or more data streams and/or to write to the one or more data streams.

7. The apparatus of claim 1, wherein a processor, having one or more processor cores, is to access the data stored in the register file entry to perform the one or more operations, or wherein the one or more operations comprise a load operation and/or a store operation.

8. The apparatus of claim 1, wherein the input data is to be read from a backing storage, or wherein the backing storage comprises Static Random-Access Memory (SRAM), or wherein a working data set is to be subdivided into a plurality of data blocks stored in the backing storage, or wherein the backing storage and the plurality of register file cells are to communicate via a lower bandwidth interconnect than an interconnect coupled between a processor and the plurality of register file cells, or wherein a die stack comprises a separate die for the backing storage than a die for the plurality of register file cells, or wherein the register file has a functional capacity which can be as large as a capacity of the backing storage.

9. The apparatus of claim 1, wherein the register file entry and the shadow buffer have a same capacity, or wherein the shadow buffer comprises at least one of a latch and a flip-flop.

10. The apparatus of claim 1, wherein a processor, having one or more processor cores, comprises the logic circuitry, or wherein the processor comprises a graphics processing unit and/or a general-purpose processor.

11. An apparatus comprising:
decode circuitry to decode an instruction having a field for an operand value; and
execution circuitry to execute the decoded instruction to perform one or more operations in accordance with the operand value,
wherein the one or more operations cause storage of input data to a shadow buffer of a register file cell, while data stored in a register file entry of the register file cell is to be accessible to execute one or more tasks.

12. The apparatus of claim 11, wherein a processor, having one or more processor cores, is to access the data stored in the register file entry to perform the one or more tasks.

13. The apparatus of claim 11, wherein a register file comprises a plurality of the register file cells, wherein contents of selected register file entries of the register file and their corresponding shadow buffers are to be at least one of exchanged and overwritten in a single clock cycle.

14. An apparatus comprising means to perform a method as set forth in any preceding claim.

15. Machine-readable storage including machine-readable instructions, when executed, to implement a method or realize an apparatus as set forth in any preceding claim.
